Europäisches Patentamt

European Patent Office

Office européen des brevets

(19)

(11) **EP 0 697 672 B1**

(12) **EUROPÄISCHE PATENTSCHRIFT**

| | |
|---|---|
| (45) Veröffentlichungstag und Bekanntmachung des Hinweises auf die Patenterteilung:<br>**15.12.1999  Patentblatt 1999/50** | (51) Int Cl.$^6$: **G06F 19/00**, G01D 3/028,<br>E05B 35/00, G01R 23/167 |

(21) Anmeldenummer: **95110308.4**

(22) Anmeldetag: **30.06.1995**

(54) **Verfahren zur Korrektur einer Messkurve oder eines Signalverlaufs, eine zugehörige Vorrichtung und dessen bzw. deren Anwendung zur Rekonstruktion von Lagefehlern bei Bahngleisen aus geometrischen Relativmessungen**

Procedure to correct a measurement curve or a signal variation, system for carrying out the method, and use for reconstruction of the error position in railway tracks by means of geometrical relative measurements

Procédé pour corriger une courbe de mesure ou la variation dans un signal, dispositif pour la mise en oeuvre de ce procédé et application pour la reconstruction des erreurs de position sur des voies de chemin de fer au moyen de mesures relatives

(84) Benannte Vertragsstaaten:
**AT CH DE FR GB IT LI NL**

(30) Priorität: **19.08.1994  DE 4429517**

(43) Veröffentlichungstag der Anmeldung:
**21.02.1996  Patentblatt 1996/08**

(73) Patentinhaber: **MAN Technologie Aktiengesellschaft**
**85757 Karlsfeld (DE)**

(72) Erfinder: **Mauer, Lutz, Dr.-Ing.**
**D-86164 Augsburg (DE)**

(74) Vertreter: **Frenzel, Holger, Dr. et al**
**Patentanwälte,**
**Hagemann, Braun & Held,**
**Postfach 86 03 29**
**81630 München (DE)**

(56) Entgegenhaltungen:
**EP-A- 0 084 001**

- **ESVELD: "das messen und korrigieren der gleisgeometrie" EISENBAHNTECHNIISCHE RUNDSCHAU, Bd. 29, Nr. 5, 1980, DARMSTADT, Seiten 351-359, XP002061334**

**Beschreibung**

Die Erfindung bezieht sich auf ein Verfahren zur Korrektur einer durch mindestens ein Meßgerät aufgenommenen Meßkurve $Y(X)$ mit Meßwerten $Y$ bzw. eines mittels eines Empfängers empfangenen Signalverlaufs $Y(X)$ mit Signalwerten $Y$ bei verschiedenen Parametern $X$, für das die Auflösung des Meßgerätes oder die Störung des Signalverlaufs durch eine Funktion $G(X)$ oder deren Fouriertransformierte $g(\omega)$ beschreibbar ist, wobei die Meßwerte $Y$ sich durch eine Faltung aus echten, durch das Meßgerät ungestörten, jedoch wegen der Auflösung nicht erfaßbaren Werten $Y_T$ oder die Signalwerte $Y$ sich durch eine Faltung aus ungestörten Signalen $Y_T$ ergeben als:

$$Y(X) = \int\limits_{-\infty}^{+\infty} G(X - X')Y_T(X')dX'.$$

Die Erfindung bezieht sich ferner auf eine Vorrichtung zur Durchführung des Verfahrens, um eine, durch ein Meßgerät aufgenommene Meßkurve oder einen mittels eines Empfängers empfangenen Signalverlauf $Y(X)$ bezüglich einer dem Meßgerät zugehörigen oder die Störung des Signalverlaufs beschreibenden Faltungsfunktion $G(X)$ zu korrigieren, von der mindestens ihre Fouriertransformierte $g(\omega)$ bekannt ist. Außerdem bezieht sich die Erfindung auch auf die Anwendung des Verfahrens und der Vorrichtung zur Rekonstruktion von Lagefehlern bei Bahngleisen aus geometrischen Relativmessungen.

Die Erfindung kann nur unter Anwendung einiger mathematischer Umformungen vollständig verstanden werden, für die in der Beschreibung folgende Nomenklatur verwendet wird:

Physikalische Größen oder durch Digitalwerte dargestellte physikalische Größen werden mit Großbuchstaben und deren Fouriertransformierte mit Kleinbuchstaben bezeichnet. Für die Darstellung komplexer Größen wird $\sqrt{-1}$ durchgehend "i" genannt. Die Fouriertransformationen werden mit positivem Exponenten $i\omega X$ und die Rücktransformationen dementsprechend mit negativem Exponenten durchgeführt, also:

$$y(\omega) = \int\limits_{-\infty}^{+\infty} e^{i\omega X} Y(X)dX$$

und

$$Y(X) = \frac{1}{2\pi} \int\limits_{-\infty}^{+\infty} e^{-i\omega X} y(\omega)d\omega.$$

Bei anderen Darstellungen der Fouriertransformation können sich andere Vorzeichen von i ergeben, die bei der Entwicklung der Lehre für andere als die dargestellten Beispiele entsprechend zu berücksichtigen sind. Statt der Fouriertransformation kann auch die in der Elektrotechnik weit verbreitete Laplacetransformation verwendet werden, deren Parameter p in der transformierten Darstellung sich aus den Fourierparametern $\omega$ durch Multiplikation mit i ergeben.

Es wird weitgehend die Integraldarstellung verwendet, die im Falle diskreter Werte oder numerischer Ausführung der Berechnungen in entsprechende Summen umzuwandeln ist. Faltungs- und Entfaltungsfunktionen können dabei in bekannter Weise durch Matrizen dargestellt werden, so daß die Entfaltungsfunktionen auch durch invertierte Matrizen der anstelle von Faltungsfunktionen verwendeten Matrizen ersetzt werden. Die Grundzüge der im folgenden angegebenen Lehre sind unabhängig von der gewählten mathematischen Darstellung anwendbar.

Das der Erfindung zugrunde liegende Problem zieht sich durch die gesamte Meßtechnik. Ein Meßinstrument hat nur eine endliche Auflösung, so daß ein Teil von physikalisch zu messenden Größen $Y_T$ nicht erfaßt werden kann, sondern nur eine Meßkurve $Y(X)$ bei der zu jedem Y verschiedene Werte der zu messenden Größen $Y_T$ bei unterschiedlichen X beitragen. Die Breite des Wertebereichs von X, innerhalb dessen die gemessenen Werte Y aus den Größen $Y_T$ bestimmt sind, wird üblicherweise als Auflösung des Meßgerätes bezeichnet. Häufig nimmt man für die Auflösung eine Verbreiterung der Parameter in Form einer Gaußkurve an und kann durch die Berücksichtigung der Fehlerfortpflanzung auch Aussagen über die mit dem Meßgerät nicht direkt erfaßbaren Größen $Y_T$ machen. Dies reicht in der Praxis aber meist nicht aus.

Als Beispiel seien hier die Röntgenkleinwinkelstreuung, die Abbildung mit dem Rasterelektonenmikroskop und Tiefenprofilmessungen mit Hilfe von Zerstäubungstechniken genannt. Bei der Röntgenkleinwinkelstreuung mißt man beispielsweise die Beugung an kleinen Teilchen zur Ermittlung ihrer Größen in Vorwärtsrichtung. Wenn Teilchen größer als die Wellenlänge des verwendeten Röntgenstrahl sind, werden die Röntgenstrahlen im wesentlichen nur in Vorwärtsrichtung gebeugt, wo Winkeldivergenzen des primären Röntgenstrahls die Auflösung stark beeinträchtigen. Die Winkeldivergenzen können zwar mit Hilfe geeigneter Kollimatoren beliebig klein gehalten werden, die Intensität sinkt dabei jedoch stark ab, so daß bei einer bestimmten guten Auflösung das Signal im Rauschen untergeht. Deshalb ist es günstiger, mit etwas geringerer Auflösung zu messen und die Größenverteilung mittels einer Korrektur der Meßgrößen zu gewinnen.

Beim Rasterelektronenmikroskop ist die Bildauflösung nicht nur durch die Breite des gerasterten Elektronenstrahls gegeben, sondern auch durch Rückstreuungen im zu vermessenden Objekt. Trotz sorgfältiger Auswahl der Meßparameter sind also in besonderen Fällen, wie in der Prozeßkontrolle bei der Halbleiterfertigung von Strukturen kleiner Abmessungen, nur Teilaussagen durch Messen allein möglich, wenn kein Verfahren zur Verfügung steht, um die Meßauflösung über die physikalischen Grenzen hinaus zu verbessern.

Bei Tiefenprofilmessungen mit der Augerelektronenspektroskopie oder der Sekundärionenmassenspektroskopie wird der zu analysierende Festkörper zerstäubt, so daß zur Konzentrationsbestimmung der Bestandteile des Festkörpers mit der Zeit immer eine andere Oberfläche vorliegt. Das heißt, durch Bestimmung der Elementzusammensetzung mit der Zeit können Konzentrationsprofile über die Tiefe gewonnen werden. Neben apparativen Verfälschungen beim Zerstäuben, beispielsweise durch Erzeugen einer gewölbten Oberfläche zum Analysieren, wird die Auflösung im wesentlichen durch physikalische Effekte beeinflußt, wie dem Durchmischen des Oberflächenmaterials beim Zerstäuben oder durch die endliche Tiefe aus der die Teilchen registriert werden. Bei MOS- Transistoren oder modernen Halbleiterbauelementen mit sogenannten "zweidimensionalen Elektronengasen" spielen aber sehr dünne Strukturen und Grenzflächen eine wesentliche Rolle, so daß auch hier ein Verfahren benötigt wird, um die durch die Messung selbst verfälschten Meßkurven auf die ursprünglichen im Meßobjekt gegebenen Werte zurückzuführen.

Allen drei genannten Beispielen ist gemeinsam, daß die Meßwerte Y am Ort X nicht nur einen Beitrag von $Y_T(X)$, sondern auch von den Größen $Y_T(X \pm \Delta)$ benachbarter Orte $X \pm \Delta$ erhalten.

Allgemein kann dies durch ein Faltungsintegral ausgedrückt werden:

$$Y(X) = \int_{-\infty}^{+\infty} G(X - X') Y_T(X') dX' \qquad\qquad 1.0$$

Die Faltungsfunktion G enthält dabei nicht nur die durch Toleranzen im Aufbau des Meßgerätes entstehenden Meßunsicherheiten, wie bei der Röntgenkleinwinkelstreuung die Divergenz des Röntgenstrahles, sondern ganz wesentlich auch physikalische Effekte, wie den Ursprung der Sekundärelektronen bei der Rasterelektronenmikroskopie oder die Veränderung der gemessenen Tiefenprofile während des Zerstäubens eines Festkörpers.

Die Integralgleichung 1.0 ist aber im allgemeinen schwer nach $Y_T(X)$ aufzulösen, wie nachfolgend deutlich wird, so daß man sich in der Physik häufig damit behilft, als Funktion $Y_T(X)$ modellmäßig als $Y_T'(X)$ mit einer Reihe von Parametern anzusetzen und die freien Parameter nach Ausführung des Integrals durch Vergleich der modellmäßig erzeugten Meßwerte mit den gemessenen Meßwerten anzupassen. Bei komplexen physikalischen Zusammenhängen ist zur Ausführung des Integrals 1.0 die Monte-Carlomethode bekannt, bei der die Auflösung durch Würfeln von Zufallszahlen simuliert wird.

Diese Verfahren sind aber in der Technik meist nicht anwendbar. Beispielsweise läßt sich für die Bestimmung der Lage von Schienen kein Modell angeben, da sie auch von nicht theoretisch physikalisch erfaßbaren Bedingungen, wie ungenaues Arbeiten beim Schienenverlegen, mitgeprägt ist. Deshalb muß hier eine allgemeinerere Möglichkeit für die Ermittlung der erwarteten Werte $Y_T'(X)$ gesucht werden.

In dem Buch von Klein, "Finite Systemtheorie", Teubner Studienbücher: Elektrotechnik, Teubner, Stuttgart, 1976 , Seite 17 ff., werden beispielsweise die Werte Y und $Y_T'$ als diskrete Werte dargestellt, so daß anstelle der in 1.0 auftretenden Funktion G eine Matrix auftritt. Das auszuführende Integral wird dabei durch eine Matrixmultiplikation ersetzt. Die diskreten Werte $Y_T$ werden dann über eine Multiplikation der inversen Matrix mit den gemessenen, diskreten Werten Y gewonnen.

Dieser Matrixformalismus ist aber bei mehreren hundert Meßwerten sehr aufwendig. Außerdem gibt es nicht für alle Matrizen eine inverse Matrix, so daß dann dieses Verfahren nicht anwendbar ist.

Zur Inversion der Integralgleichung 1.0 verwendet man auch die Tatsache, daß ein Faltungsintegral in der Fourierdarstellung ein Produkt ergibt. Entsprechend ist die Gleichung 1.0 mit den Fouriertransformierten y, $y_T$ und g der Funktionen $Y, Y_T$ und G das Produkt:

$$y(\omega) = g(\omega) y_T(\omega), \qquad\qquad 1.1$$

wobei $\omega$ eine Frequenz, die Variable in der Fourierdarstellung, ist. Die Fouriertransformierte $y_T(\omega)$ von $Y_T(X)$ kann deshalb durch einfaches Teilen der Gleichung 1.1 durch $g(\omega)$ gewonnen werden:

$$y_T(\omega) = y(\omega)/g(\omega)$$

Verwendet man nun die Regel, daß ein Produkt von Fouriertransformierten ein Faltungsintegral im Ortsraum darstellt, kann man auch schreiben:

$$Y_T(X) = \int_{-\infty}^{+\infty} G^{-1}(X - X')Y(X')dX',$$

wobei die auch als Entfaltungsfunktion bezeichnete Funktion $G^{-1}(X)$ mittels Fourierrücktransformation aus $1/g(\omega)$ gewonnen wird.

Es werden auch andere Möglichkeiten zur Gewinnung der Entfaltungsfunktion verwendet. Eine Methode, die der vorhergehend genannten Matrixinversion äquivalent ist, besteht in der Lösung der Integralgleichung:

$$\int_{-\infty}^{+\infty} G^{-1}(X - X')G(X' - X'')dX' = \delta(X - X''), \qquad\qquad 2.0$$

wobei $\delta(X)$ die Diracsche Nadelfunktion ist, die über ihr Integral definiert ist:

$$\int_{c}^{d} \delta(X)dX = \begin{cases} 1, & \text{wenn } c < 0 < d; \\ -1, & \text{wenn } c > 0 > d; \\ 0 & \text{in allen anderen Fällen.} \end{cases}$$

Die Fouriertransformierte von $\delta(X)$ ist 1. Die Integralgleichung 2.0 gibt deshalb auch wieder, daß die Fouriertransformierte von $G^{-1}(X)$ gleich $1/g(\omega)$ ist.

Ein solches Verfahren wurde zum beispiel in der EP 0 084 001 zur Verbesserung seismologischer Messungen angegeben.

Obwohl der beschriebene Formalismus sehr einfach aussieht, ist dessen Anwendung in der Praxis aus folgenden Gründen häufig problematisch:

1. Die in der Meßtechnik vorkommenden Funktionen $G(X)$ sind üblicherweise, da ja eine gute Auflösung immer gefordert ist, Funktionen, die für große Absolutwerte von X stark abfallen. Das bedeutet, daß $g(\omega)$ im wesentlichen nur Anteile sehr hoher Frequenzen enthält und für sehr große Absolutwerte von $\omega$ verschwindet oder asymptotisch gegen Null geht.

2. Die Funktion $g(\omega)$ besitzt in vielen Fällen Nullstellen.

In beiden Fällen ist die Funktion $1/g(\omega)$ nicht nach oben beschränkt, deshalb existiert von dieser keine Fouriertransformierte. $G^{-1}(X)$ läßt sich dann nicht berechnen.

Das erste Problem läßt sich wie gemäß EP 0 084 001 durch eine Näherung umgehen, indem bei der Rücktransformation nur über einen begrenzten Frequenzbereich integriert wird. Dann erhält man eine genäherte Entfaltungsfunktion, die allerdings bei sehr kleinen Abständen nicht mehr den richtige Meßgröße wiedergibt. Diese genäherte Entfaltungsfunktion verbessert also die Auflösung des Meßgerätes, kann aber die wahren vorliegenden Meßwerte nicht reproduzieren. Das ist für die meisten praktischen Fälle ausreichend, vor allem, da man durch die Wahl der Beschränkung des Frequenzbereichs jede beliebige, gewünschte Auflösung vorgeben kann.

Das zweite Problem ist wesentlich schwieriger zu lösen, vor allem, wenn eine Nullstelle $g(\omega \approx 0) = 0$ existiert. Würde man hier den Integrationsbereich zur Vermeidung der Pole einschränken, würden die kleinen Frequenzen bei der Integration nicht berücksichtigt. Es ergäbe sich also ein großer Fehler im Bereich großer $X$, wo üblicherweise die Auflösung keine Rolle spielt. Die Entfaltung führt dann selbst zu einer nicht tolerierbaren Verfälschung in Bereichen, in denen das Meßgerät ohne Korrektur hinreichend genaue Meßwerte erfaßt.

Bei $\omega \cong 0$ verschwindende $g(\omega)$ sind beispielsweise bei der Rekonstruktion von Lagefehlern beim Gleisbau problematisch. Zur Korrektur von Gleislagefehlern benötigt man möglichst genaue Angaben über ihre Art, Größe und Lage. Ihre Messung erfolgt nicht direkt, sondern die Lagefehler müssen aus geometrischen Relativmessungen rekonstruiert werden.

Ein möglichst glatter Schienenverlauf ist zum einen für die Verringerung dynamischer Radkräfte zweckmäßig, zum anderen zur Verbesserung des Fahrkomforts durch Verringerung der Schwingungsanregung. Nicht nur durch die Optimierung für die dynamischen Radkräfte, sondern auch durch die Vermeidung von Schwingungen der Wagen von Zügen kann Energie eingespart werden. Außerdem ist eine Verringerung der dynamischen Radkräfte wünschenswert, damit Verschleiß und die Komponentenbeanspruchung verringert sind und die Wartungsintervalle groß gehalten werden können.

Die Vermessung von Gleislagefehlern ist in P. N. Bhaskaran, "Gleißmeßverfahren-Begriffe und Technik", Schienen der Welt, 1972, Seiten 448-456; Coenraad Esveld, "Das Messen und Korrigieren der Gleisgeometrie", ETR (29)5, 1980, Seiten 351 bis 359, und Coenraad Esveld, "Modern Railway Track", MRT-Productions, Duisburg, 1989, Seiten 276-310, beschrieben.

Die Lagefehler werden üblicherweise durch eine Höhenmessung des Gleises bestimmt. Die Messung erfolgt dabei über eine "Wandersehne". Durch vor- und nachlaufende Räder oder Tastscheiben eines Gleismeßwagens wird dabei eine Sehne über dem gekrümmten Gleis definiert. Der Meßfühler, mit dem das Gleis abgetastet wird, befindet sich meist innerhalb der Sehne. In der Praxis werden symmetrische und asymmetrische Sehnenteilungen angewandt. Bei einer Krümmung in Form einer Erhöhung des Gleises zeigt der Meßfühler aber nicht nur dann einen Meßwert an, wenn der Meßfühler die Erhöhung abtastet, sondern auch, wenn das vorlaufende oder nachlaufende Rad des Wagens von dieser angehoben werden. Die Meßwerte Y ergeben sich also aus einer Faltung gemäß Gleichung 1.0, wobei die Faltungsfunktion G durch den Aufbau des Meßwagens bestimmt ist. Für kleine X ist eine Verfälschung durch die zusätzliche Abtastung des Hinter- und des Vorderrades des Wagens gegeben. Für sehr große Abstände X gegenüber den Wagenabmessungen ist überhaupt keine Aussage mehr möglich, da die Empfindlichkeit für sehr große Wellenlängen stark abfallt.

Ab einer Wellenlänge von 30-40 Metern konnten bisher keine Aussagen mehr gemacht werden. Bei Gleismeßfahrzeugen, die statt einer Höhenmessung Beschleunigungsaufnehmer einsetzen, können zwar Aussagen über bis zu 70 Metern Gleislänge gemacht werden, eine wesentliche Verbesserung für große Abstände kann aber wegen der Ungenauigkeit der notwendigen Doppelintegration von Beschleunigungssignalen nicht erwartet werden. Außerdem geht die Information über kleine Wellenlängen durch die Integrationsungenauigkeit für hohe Frequenzen verloren.

Die bisherigen Meßverfahren sind bei der heutigen Bahntechnologie unzureichend. Bei Hochgeschwindigkeitszügen mit Geschwindigkeiten von etwa 80 m/s und zu vermeidenden Resonanzfrequenzen in der Größenordnung von 1 Hz am Zug muß zur Verbesserung des Fahrkomforts die Größe der Gleislagefeher bis über 100m gut genug bekannt sein.

Es konnten bisher deshalb auch keine Entfaltungen angewandt werden, da die Fouriertransformierte der Faltungsfunktion bei kleinen Frequenzen verschwindet, wie später noch an Ausführungsbeispielen gezeigt wird. Bisher wurden die aufgenommenen Daten entweder mit viel Erfahrung direkt oder über die Ermittlung der Leistungsdichte aus dem Fourierspektrum der Meßwerte interpretiert. Die die genaue Lage und Form der Gleisfehler beinhaltende Phaseninformation geht dabei aber verloren.

Die beschriebenen Faltungen und notwendigen Entfaltungen spielen aber nicht nur bei Meßwerten in Meßkurven eine Rolle, sondern sind auch auf Verfälschungen von Signalen anwendbar. Dazu sei beispielhaft der Fernseh- oder Satellitenempfang genannt. Eine Antenne empfängt nicht nur die primäre Welle, sondern auch Streuwellen, die beispielsweise von Gebäuden zurückgestrahlt werden. Durch die unterschiedliche Laufzeit des Signals von den Streuwellen relativ zu den primären Wellen entstehen beispielsweise beim Fernsehen unerwünschte Schattenbilder.

Derartige Verfälschungen eines Signalverlaufs lassen sich auch als Faltung darstellen, wobei der Parameter X die Zeit ist und die Faltungsfunktion G sich aus dem gesendeten Signal und den reflektierten Signalen zusammensetzt. Eine Entfaltung ist bei derart schnellen Signaländerungen, wie beim Fernsehen, nicht möglich gewesen, da die Signale bei den heutzutage mehr oder weniger durch mathematischen Algorithmus ausgeführten, genannten Entfaltungsverfahren nicht schnell genug bearbeitet werden können. Deshalb ist es wünschenswert, auch eine Vorrichtung zur Verfügung zu haben, mit der Signalverläufe schnell genug in Art einer Entfaltung umgewandelt werden können. Auf eine genaue Entfaltung kann man beispielsweise zur Verbesserung des Fernsehempfangs verzichten, denn hier hat die Schnelligkeit Vorrang. Es bleibt aber die Forderung bestehen, daß kleine Frequenzen und große Frequenzen bei einer genäherten Entfaltung gleich gut berücksichtigt werden, damit in allen Frequenzbereichen die Auslöschung des Schattenbildes möglich ist.

Die Verfälschung von Signalen beruht auf dem gleichen Formalismus wie die Verfälschung von Meßwerten. Deshalb tritt die gleiche Problematik auf.

Die vorstehenden Beispiele für Meßwerte zeigten, daß sich eine Entfaltung für kleine und große Parameter X häufig nicht mit gleich guter Genauigkeit durchführen läßt, die Standardverfahren also für eine Auflösungserhöhung, insbesondere bei der Ermittlung von Gleislagefehlern, nicht mit der gewünschten Genauigkeit durchführbar waren.

Aufgabe der Erfindung ist es, ein Verfahren und eine Vorrichtung zu schaffen, um die Auflösung eines Meßgerätes zu erhöhen, bei dem oder bei der die nicht erfaßbaren Größen $Y_T(X)$ aus einer aufgenommenen Meßkurve $Y(X)$ als $Y_T'(X)$ bestimmt werden, wobei die Größen $Y_T(X)$ sowohl für große Parameter X als auch für kleine Parameter X mit gewünschter Genauigkeit wiedergegeben werden Die Aufgabe bezieht sich auch auf die richtige Wiedergabe von Signalverläufen bei Verfälschung durch mittels einer Faltung darstellbare Störungen. Insbesondere soll das Verfahren oder die Vorrichtung bei der Bestimmung relativer Lagefehler von Bahngleisen einsetzbar sein.

Die Aufgabe wird durch ein Verfahren gelöst, bei dem aus der Meßkurve oder dem Signalverlauf $Y(X)$ entsprechend ihrer bzw. seiner Fourierdarstellung $y(\omega)$ ein hochfrequenter Anteil $Y_1(X)$ und ein niederfrequenter Anteil $Y_2(X)$ mit seiner Fourierdarstellung $y_2(\omega)$ so gefiltert werden, daß das Filtern für den hochfrequenten Anteil $Y_1(X)$ mit Hilfe einer angenäherten, einer Faltungsfunktion $G_{APPR}(X)$ durch Invertieren zugeordneten Entfaltungsfunktion $G_{APPR}^{-1}(X)$ durch

$$Y_1(X) = \int_{-\infty}^{+\infty} G_{APPR}^{-1}(X - X')Y(X')dX'$$

und das Filtern für den niederfrequenten Anteil in der Fourierdarstellung durch

$$y_2(\omega) = f(\omega) \cdot y(\omega)$$

mit einer für hohe Frequenzen $\omega$ stark gegen Null abfallenden Funktion $f(\omega)$ darstellbar ist, wobei die Funktionen $G_{APPR}(X)$ und $f(\omega)$ so gewählt werden, daß eine Funktion

$$z(\omega) = f(\omega)\frac{g_{APPR}(\omega) \cdot g(\omega)}{g_{APPR}(\omega) - g(\omega)}$$

mit $g_{APPR}(\omega)$ der Fouriertransformierten von $G_{APPR}(X)$ durch eine Potenzreihe $p(\omega)$ mit Koeffizienten $a_k$

$$z(\omega) \cong p(\omega) = \sum_{k=0}^{N} a_k \omega^k$$

approximiert werden kann und die korrigierte Meßkurve oder der korrigierte Signalverlauf $Y_T'(X)$ durch $Y_T'(X) = Y_1(X) + H(X)$ gewonnen wird, wobei für $H(X)$ die Differentialgleichung

$$\sum_{k=0}^{N} a_k (-i)^k \frac{d^k}{dX^k} H(X) = Y_2(X) \qquad\qquad 3.0$$

gelöst wird, und die Integrationskonstanten der Lösung $H(X)$ durch die meßtechnischen oder durch den wahren Signalverlauf gegebenen Randbedingungen bestimmt sind.

Das Verfahren verwendet also eine approximative Entfaltung über eine Funktion $G_{APPR}^{-1}(X)$ und die Lösung einer Differentialgleichung. Es basiert auf folgender Umformung:

$$\frac{1}{g(\omega)} = \frac{1}{g_{APPR}(\omega)} + \frac{f(\omega)}{f(\omega)\dfrac{g_{APPR}(\omega)\cdot g(\omega)}{g_{APPR}(\omega)-g(\omega)}}.$$

Der erste Summand beschreibt dabei eine Entfaltung mit einer angenäherten Entfaltungsfunktion $G_{APPR}^{-1}(X)$, die aus einer invertierbaren Faltungsfunktion $G_{Appr}(X)$ gebildet wird. Der zweite Term beschreibt einen Korrekturterm zur genauen Entfaltungsfunktion. Er wird um so kleiner, je besser die Funktion $g(\omega)$ durch die Funktion $g_{APPR}(\omega)$ angenähert wird. Im allgemeinen ist man bei der Verbesserung der Auflösung von Meßkurven an der genauen Wiedergabe der Meßwerte bei kleinen Parametern X und damit hohen Frequenzen $\omega$ interessiert, so daß man vor allem die Entfaltungsfunktion bei sehr hohen Frequenzen approximiert.

Dann enthält der zweite Term im wesentlichen nur Terme bei niedrigen Frequenzen. Die Funktion $f(\omega)$ im Zähler wird deshalb dazu verwendet, niedrige Frequenzen aus den Meßkurven oder den Signalverläufen auszufiltern, die allein bei der Auswertung des Korrekturterms berücksichtigt werden müssen. Die Frequenz, bei der eine Filterfunktion stark abfällt, wird im allgemeinen mit Eckfrequenz bezeichnet.

Die Eckfrequenz von $f(\omega)$ beschränkt dann auch den Nenner des Korrekturterms, der im folgenden mit $z(\omega)$ bezeichnet wird. Bei entsprechender Wahl von $g_{APPR}(\omega)$ und $f(\omega)$ läßt sich erreichen, daß der Zähler im Frequenzbereich bis zur Eckfrequenz nicht divergiert, so daß sich der Nenner durch eine Potenzreihe $p(\omega)$ N-ter Ordnung mit Koeffizienten $a_k$ annähern läßt:

$$z(\omega) \cong p(\omega) = \sum_{k=0}^{N} a_k \omega^k.$$

Singularitäten, die keine Inversion der Faltungsfunktion erlauben, treten nun im Korrekturterm, beispielsweise als Nullstellen der Funktion $p(\omega)$, auf. Durch Verwendung der benutzten Umformung allein ist also das Problem noch nicht gelöst.

Für die Auswertung des Korrekturterms wird von dem Formalismus der Lösung von Differentialgleichungen mittels Greensfunktionen Gebrauch gemacht:

Der Korrekturterm läßt sich durch eine Funktion $h(\omega)$ ausdrücken:

$$h(\omega) = \frac{y_2(\omega)}{p(\omega)}$$

mit $y_2(\omega) = f(\omega)\cdot y(\omega)$.

Für die Funktionen $Y_2(\omega)$ und $H(\omega)$, deren Fouriertransformierten die Funktionen $y_2(\omega)$ bzw. $h(\omega)$ sind, gilt, wie man sich durch Fouriertransformation überzeugt, die folgende Differentialgleichung:

$$\sum_{k=0}^{N} a_k (-i)^k \frac{d^k}{dX^k} H(X) = Y_2(X).$$

Bei der Lösung dieser Differentialgleichung spielen Divergenzen keine Rolle mehr, wenn die physikalischen Randbedingungen in den Integrationskonstanten mit berücksichtigt werden, da sich dann nur technisch relevante Lösungen ergeben können, bei denen Divergenzen prinzipiell ausgeschlossen sind.

Die Entfaltung wird bei dem Verfahren also so durchgeführt, daß zuerst aus den Meßkurven oder den Signalen ein niederfrequenter Anteil $Y_1$ und ein hochfrequenter Anteil $Y_2$ ausgefiltert werden, wobei das Filtern des hochfrequenten Anteils über $G_{APPR}^{-1}$ schon eine genäherte Entfaltung darstellt. Der dann fehlende niederfrequente Anteil wird durch Lösung der Differentialgleichung 3.0 ermittelt.

Dieses Verfahren läßt sich rechentechnisch ohne Rücksicht auf die Fourierdarstellung durchführen. Das hat den Vorteil, daß die Funktionen nicht im gesamten verfügbaren Definitionsbereich der Parameter X vorliegen müssen und die Entfaltung schon während der Aufnahme der Meßkurven bzw. zeitgleich zum Signalverlauf ausgewertet werden kann. Das korrigierte Signal oder der korrigierte Meßwert stehen also praktisch immer zeitgleich oder um ein festes Intervall verzögert zum Zeitpunkt der Aufnahme des verfälschten Meßwertes Y zur Verfügung. Das ist besonders beim Einsatz des Verfahrens in der Überwachung von Prozessen wichtig, da beim Auftreten unerwünschter, durch die Korrektur erfaßter Effekte im Prozeß sofort gegengesteuert werden kann.

Das erfindungsgemäße Verfahren läßt sich beispielsweise unter Einsatz von Digitalrechnern durchführen. Da die Entfaltung aber nur Filter und zur Lösung der Differentialgleichung beispielsweise einen Analogrechner mit einer begrenzten Anzahl von Integratoren benötigt, kann es vor allem auch bei der Signalaufbereitung schaltungstechnisch verwirklicht werden. Vorteilhafterweise kann das Verfahren somit auch zur Aufbereitung sehr schneller Signale verwendet werden, für welche die Datenerfassung und Auswertung mit einem Digitalrechner zu langsam ist.

In der technischen Realisierung mit Hilfe elektrischer Schaltungen ist das Verfahren allerdings nicht beschränkt. Auch in der Mechanik können durch Federn verschiedene Frequenzanteile ausgefiltert werden und Lösungen von Differentialgleichungen bewegungsmäßig dargestellt werden, wie aus der Konstruktion mechanischer Integratoren bekannt ist.

Die vielfältigen Einsatzmöglichkeiten sind vor allem vorteilhaft dadurch gegeben, daß die Funktionen $g_{APPR}$ ($\omega$) und $f(w)$ in großem Maße frei gewählt werden können. Durch den großen Freiheitsgrad zur Auswahl dieser Funktionen läßt sich praktisch jede technisch interessante Entfaltung mit technischen Mitteln realisieren. Dies wird im folgenden noch bei der Diskussion von Weiterbildungen der Erfindung und von Ausführungsbeispielen deutlich werden.

Da das erfindungsgemäße Verfahren sehr vielfältig einsetzbar ist, wäre es sinnvoll, es für unterschiedliche Anwendungen zu standardisieren. Dann könnte beispielsweise ein einziges elektronisches Gerät zur Signalaufbereitung für die verschiedensten Anwendungen geschaffen werden. Signalverzerrungen treten bekanntlich sowohl beim Satellitenempfang, als auch bei der Telefonübertragung und bei Datenleitungen in unterschiedlichster Weise auf.

Die Filter sind für eine Standardisierung unproblematisch, da sie leicht variabel ausgelegt werden können. Eine Einrichtung zur Lösung der Differentialgleichung 3.0 muß aber, wenn sie sowohl für komplexe Probleme als auch einfache Probleme einsetzbar sein soll, entweder über- oder unterdimensioniert sein. Dies gilt vor allem, wenn sich der Grad N der Potenzreihe $p(\omega)$ von Anwendung zu Anwendung stark unterscheidet.

Deswegen sieht eine vorteilhafte Weiterbildung der Erfindung vor, daß die Lösung $H(X)$ durch eine Summe von N Integralen

$$A_{ln}\,(-i)^n\,e^{-i\omega_l X}\int\,...\int\,e^{-i\omega_l X}\,Y_2\,(X)\,dX^n \qquad\qquad 4.0$$

gebildet wird, wobei die $\omega_l$ die N komplexen Nullstellen der Potenzreihe $p(\omega)$ bezeichnen und die Zahl der Integrationen n und die Koeffizienten $A_{ln}$ jeweils die Potenz und der Koeffizient des Partialbruchs

$$\frac{A_{ln}}{(\omega - \omega_l)^n}$$

Die Partialbruchzerlegung führt auf eine Summe einfach zu integrierender Ausdrücke zur Lösung der Differentialgleichung für $H(X)$. Daraus ergibt sich schaltungstechnisch die Möglichkeit, genügend Steckplätze für Integratoren bzw. Oszillatoren zur Erzeugung der Frequenzen $\omega_l$ vorzusehen, mit denen eine Schaltung für verschiedene Anwendung sowohl komplexe Entfaltungen bei genauer Entfaltung oder auch einfache Entfaltungen mit weniger Aufwand zu verwirklichen gestattet, wobei die Integratoren bzw. Oszillatoren je nach Bedarf eingesteckt werden können.

Aber auch bei numerischer Entfaltung mit Hilfe eines Digitalrechners bietet diese Weiterbildung Vorteile für die Anpassung an das jeweilige Problem. Die standardisierte Auswertung einzelner Summanden mit dem Integral 4.0 erlaubt die Lösung der Differentialgleichung über eine Schleife, dessen Bereich der Laufparameter für komplexere Probleme einfach hochgesetzt wird, und die zusätzlichen benötigten Parameter $A_{ln}$ und $\omega_1$ werden dann nur durch Erweiterung eines Datenfeldes oder eine DATA-Anweisung berücksichtigt.

Die Weiterbildung beruht auf der folgenden Rücktransformation einer Funktion

$$k(\omega) = \frac{y_2(\omega)}{(\omega - \omega_l)^n},$$

deren inverse Fouriertransformation die Funktion

$$K(X) = \frac{1}{2\pi} \int_{-\infty}^{+\infty} e^{-i\omega X} k(\omega) d\omega = \frac{1}{2\pi} \int_{-\infty}^{+\infty} e^{-i\omega X} \frac{y_2(\omega)}{(\omega - \omega_l)^n} d\omega$$

ergibt. Multiplikation mit $e^{i\omega_l X}$ und n-fache Ableitung der Beziehung führt zu:

$$\frac{d^n}{dX^n} e^{i\omega_l X} K(X) = (-i)^n \frac{1}{2\pi} \int_{-\infty}^{+\infty} e^{-i(\omega - \omega_l)X} y_2(\omega) d\omega$$

Weitere Multiplikation mit $e^{-i\omega X}$ der Gleichung unter Berücksichtigung von

$$Y_2(X) = \frac{1}{2\pi} \int_{-\infty}^{+\infty} e^{-i\omega X} y_2(\omega) d\omega$$

ergibt die Beziehung:

$$e^{-i\omega_l X} \frac{d^n}{dX^n} e^{i\omega_l X} K(X) = (-i)^n Y_2(X)$$

Die Umstellung dieser Gleichung nach $K(X)$ führt sofort zu dem Integralausdruck 4.0 .

Im allgemeinen können die Nullstellen $\omega_l$ komplex sein. Dann treten unter dem Integranden und vor den Integralen Exponentialfunktionen auf. Dies bereitet bei der numerischen Auswertung des Integrals 4.0 weiter keine Schwierigkeiten. Bei einer schaltungstechnischen Ausführungsform müssen aber die Exponenten bei sehr großen Parametern X jeweils auf kleinere Werte zurückgesetzt werden, so daß ein großer Aufwand erforderlich wird.

Deswegen ist bei einer vorteilhaften Weiterbildung des erfindungsgemäßen Verfahrens vorgesehen, die Funktion $f(\omega)$ so zu wählen, daß die Potenzreihe $p(\omega)$ N-ten Grades genau N Nullstellen aufweist. Dann werden alle Nullstellen der Potenzreihe reell und die Exponentialfunktionen in den Integranden verschwinden. Der Integralausdruck 4.0 läßt sich dann bei der Signalverarbeitung durch einfache Oszillatoren, Integratoren und Multiplizierer nachbilden.

Die Bedingung läßt sich in der Praxis dadurch erfüllen, daß bei dem Filter für die niedrigen Frequenzen bei bestimmten Frequenzen eine Phasendrehung um 180° vorgesehen wird. Bei diesen Frequenzen erfolgt dann ein Nulldurchgang in der Potenzreihe, so daß die Nullstellen festgelegt sind. Die zur Korrektur notwendige Phasenrückdrehung erfolgt bei der Auswertung des Integralausdrucks 4.0 .

Bei einer vorzugsweisen Weiterbildung des erfindungsgemäßen Verfahrens werden die Funktionen $G_{APPR}(X)$ und $f(\omega)$ so gewählt, daß $z(0)=0$ ist. Dies läßt sich insbesondere dadurch erreichen, daß für die Funktionen $g_{APPR}(\omega)$ und/oder $f(\omega)$ schnell gegen Null abfallende Funktionen gewählt werden.

Dann hat die Potenzreihe $p(\omega)$ mindestens eine Nullstelle bei der Frequenz 0, so daß sich der Integralausdruck 4.0 an dieser Nullstelle ausschließlich auf Integrale ohne Exponentialfaktoren reduziert, was sowohl eine numerische Durchführung als auch eine schaltungstechnische Ausführung zur Verwirklichung des Verfahrens besonders einfach macht.

Bei einer anderen bevorzugten Weiterbildung des erfindungsgemäßen Verfahrens werden die Funktionen

$G_{APPR}(X)$ und $f(\omega)$ so gewählt, daß $z(\omega) = z(-\omega)$ ist. Dadurch werden die Potenzen mit ungeradem Exponenten vermieden.

Das hat zum einen den Vorteil, daß sich die Schaltung zur Lösung der Differentialgleichung auf die Hälfte nötiger Integrationsstufen reduziert. Weiter entfällt die Behandlung der Entfaltung mit komplexen Zahlen weitgehend, da die imaginäre Basisgröße i nur durch die geraden Potenzen der Frequenz in die angegebenen Gleichungen und Umformungen eingeht. Durch das Vermeiden von Termen mit ungeraden Potenzen läßt sich deswegen bei der schaltungstechnischen Verwirklichung des Verfahrens der Aufwand zusätzlicher phasenverschiebender Elemente oder Verzögerungsleitungen verringern.

Während sich die vorangehenden Weiterbildungen der Erfindung mit dem niederfrequenten Filtern befassen, werden bei den folgenden Weiterbildungen vorteilhafte Maßnahmen für das hochfrequente Filtern angegeben.

Der hochfrequente Anteil der Funktion G(X) entsteht vor allem aus den Anteilen bei sehr kleinen X. Um die Funktion $G_{APPR}(X)$ bei hohen Frequenzen G möglichst gut anzunähern, sollten beide Funktionen im Hochfrequenzbereich weitgehend übereinstimmen.

Deswegen sieht eine bevorzugte Weiterbildung des erfindungsgemäßen Verfahrens vor, daß die angenäherte Faltungsfunktion $G_{APPR}(X)$, aus der die Auflösung des Meßgerätes oder die die Störung des Signalverlaufs beschreibende Funktion $G(X)$ durch Multiplikation mit einer für große Absolutwerte von $X$ abfallenden Fensterfunktion $W(X)$ gewonnen wird, die bei $X{=}0$ den Wert 1 annimmt.

Damit wird die Faltungsfunktion G(X) bei geeigneter Fensterfunktion durch die Faltungsfunktion $G_{APPR}(X)$ genähert. Vorteilhafterweise treten Nullstellen der Funktion g(ω) bei niedrigen Frequenzen in $g_{APPR}(\omega)$, bei geeigneter Wahl von W(X), nicht auf, denn bei kleinen ω ist die Fouriertransformierte immer identisch mit dem Integral der zu transformierenden Funktion, dessen Wert durch das Einführen der Fensterfunktion verändert wird.

Um eine möglichst gute Übereinstimmung in einem großen Frequenzbereich zu erzielen, sollte der Frequenzbereich, in dem beide Funktionen $g_{APPR}$ und g ähnlich sind, möglichst groß sein. Deswegen sieht eine vorteilhafte Weiterbildung des erfindungsgemäßen Verfahrens vor, daß zweite und höhere Ableitungen der Fensterfunktion $W(X)$ in der Umgebung von X=0 verschwinden.

Dadurch ist sichergestellt, daß die Funktionen $G_{APPR}$ und G über einen größeren Parameterbereich ähnlich sind, da dann die Fensterfunktion höchstens Beiträge proportional ω hinzufügt, statt höherer Potenzen der Frequenz, wie es von höheren Ableitungen als der ersten zu erwarten ist.

Die Korrektur von Signalverläufen und Meßkurven wurde bisher beispielhaft sowohl mit schaltungstechnischen Realisierungen als auch mit digitalen Prozessoren angesprochen. Beide Methoden sind insofern äquivalent, als schaltungstechnische Funktionen aktiver Filter auch über Programme für Prozessoren nachgebildet werden können.

Jedoch erlauben Prozessoren auch bei verringertem schaltungstechnischen Aufwand die Anwendung komplexer Filter, die dem jeweiligen Problem wesentlich besser angepaßt werden können. Diese Flexibilität ist vorteilhaft bei einer bevorzugten Weiterbildung der Erfindung gegeben, bei der das Filtern über digitale Filter erfolgt.

Digitale Filter sind dem Fachmann beispielsweise aus dem Buch von U. Tietze und Ch. Schenk, "Halbleiter-Schaltungstechnik", Springer-Verlag, Berlin- Heidelberg- New York- Tokyo, 1985, Kapitel 22, bekannt. Für die praktische Anwendung können jeweils die geeigneten Filter diesem Buch oder weiterer Literatur entnommen werden.

Die Anwendung digitaler Filter erlaubt es auch, beliebig neu definierte Filterfunktionen, die in Art von Faltungsintegralen auf die zu filternde Funktion darstellbar sind, im Verfahren einzusetzen. Beispielsweise können auch rekursive Filter benutzt werden, bei denen die vorherigen Ergebnisse bei der Berechnung des nächstfolgenden Schritts berücksichtigt werden. Ihr Einsatz erlaubt sehr steile Filterkurven in der Nähe der Eckfrequenz und damit eine sehr genaue Trennung von Hochfrequenz- und Niederfrequenzanteilen.

Ein besonders starker Abfall ist vor allem für die Funktion f(ω) erwünscht, denn eine Potenzreihe p(ω) wird im allgemeinen nur in einem begrenzten Intervall mit der Funktion z(ω) übereinstimmen. Deswegen ist für eine genaue Approximation gemäß einer vorteilhaften Weiterbildung des erfindungsgemäßen Verfahrens vorgesehen, daß das Filter zur Gewinnung des niederfrequenten Anteils $Y_2(X)$ ein rekursives Filter ist. Dadurch wird die Genauigkeit des Korrekturverfahrens vorteilhafterweise erhöht.

Bei einer vorzugsweisen Weiterbildung der Erfindung enthält die Potenzreihe $p(\omega)$ nur einen einzigen, nicht verschwindenden Koeffizienten $\alpha_k$, so daß die Lösung $H(X)$ der Differentialgleichung durch eine Ein- oder Mehrfachintegration des niederfrequenten Anteils $Y_2(X)$ gewonnen wird und die Koeffizienten der digitalen Filter durch Wahl von $f(\omega)$ und $g_{APPR}(\omega)$ für $z(\omega) \approx p(\omega)$ angepaßt werden.

Diese Weiterbildung macht vor allem von den großen Auswahlmöglichkeiten bei digitalen Filtern Gebrauch. Durch die angegebene spezielle Wahl der Filterfunktionen wird die Lösung H(X) der Differentialgleichung 3.0 durch eine Mehrfachintegration gewonnen, was den Aufwand und die Verarbeitungszeit gegenüber der Lösung einer komplexen Differentialgleichung stark reduziert.

Gemäß einer vorzugsweisen Weiterbildung der Erfindung ist das Filter zur Gewinnung des niederfrequenten Anteils $Y_2(X)$ ein Besselfilter, dessen Ordnung so gewählt wird, daß der Hochfrequenz- und der Niederfrequenzanteil

von $y_T(\omega)$, der Fouriertransformierten von $Y_T(X)$, mit nur geringer Steigung ineinander übergehen, wenn die Meßkurve oder der Signalverlauf $Y(X)$ durch $G_{APPR}(X)$ simuliert wird.

Das Besselfilter zeichnet sich gegenüber anderen digitalen Filtern durch eine frequenzunabhängige Gruppenlaufkeit aus. Deswegen lassen sich die in den Umformungen vorkommenden Faktoren als rein reelle Zahlen darstellen, wodurch der rechentechnische Aufwand gegenüber dem bei der Verwendung komplexer Zahlen erniedrigt wird.

Besselfilter sind in verschiedenen Ordnungen darstellbar, wobei sich die verschiedenen Ordnungen im wesentlichen durch den Abfall bei der Eckfrequenz äußern. Mit Auswahl der richtigen Ordnung läßt sich also ein optimaler Übergang vom hochfrequenten zum niederfrequenten Anteil sicherstellen, so daß alle Frequenzen bei der genannten Korrektur von Meßkurven oder der Signalaufbereitung gleichermaßen Berücksichtigung finden. Als Kriterium zur Auswahl wird das Signal $Y(X)=\delta(X)$, also $y_T(\omega)=$ const. , $y(\omega)=g(\omega)$ gewählt, was sicherstellt, daß alle Frequenzen gleich behandelt werden.

Die zur Lösung der Differentialgleichung vorgeschlagenen Integrationen lassen sich in verschiedenster Weise durchführen. Die Genauigkeit von Integrationen soll aber genügend hoch sein, damit sich Integrationsfehler nicht so weit fortpflanzen, daß die numerische Lösung nach einer Zeit im wesentlichen nur noch durch Integrationsfehler bestimmt ist.

Die Genauigkeit eines jeden Integrationsverfahrens läßt sich dadurch verbessern, daß die Anzahl der Meßwerte im Integrationsintervall erhöht wird. Dies stößt in der Praxis meist auf Grenzen, da Meßkurven zur Behandlung nur bis zu einer Abtastfrequenz digital erfaßt werden können.

Ein Verfahren für die Integration hoher Genauigkeit ist beispielsweise die Gaußintegration, bei der aber die Parameterwerte X zur Integration unterschiedlichen Abstand haben, was häufig nicht praxisgerecht ist.

Gleiche Abstände zwischen den Parametern X der datenmäßig erfaßten Meßwerte sind zur numerischen Behandlung der Integration beispielsweise bei der bekannten Simpsonregel und der Trapezregel gegeben. Eine Gegenüberstellung der verschiedenen Integrationsmethoden ist beispielsweise in dem Buch von Richard W. Hamming, "Digitale Filter", VCH Verlagsanstalt, Weinheim, 1987, S. 65 ff., angegeben.

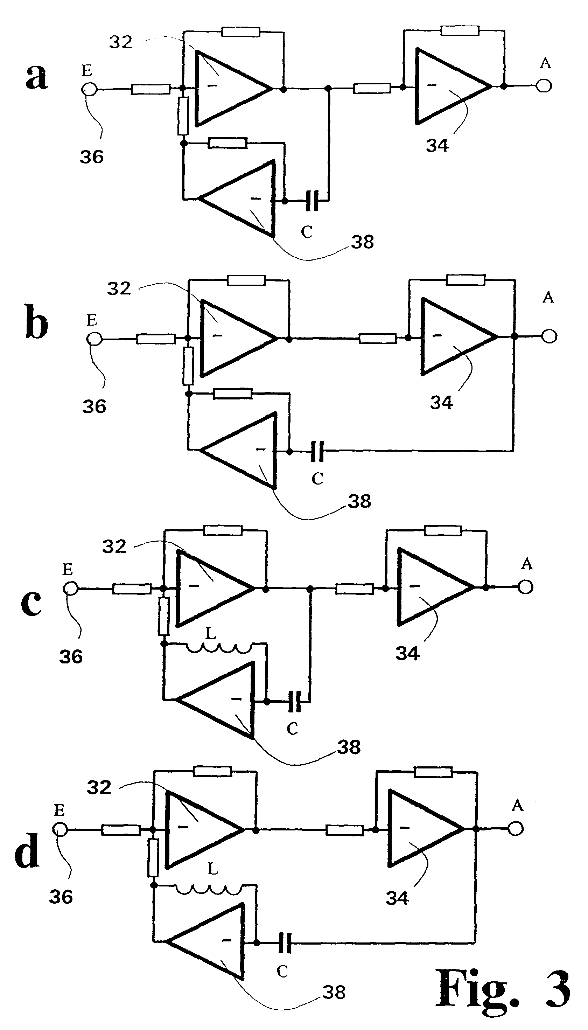

Gemäß einer bevorzugten Weiterbildung des erfindungsgemäßen Verfahrens wird für die Integration die Ticksche Regel angewandt. Diese ist eine empirisch gefundene Regel, bei welcher der Integrationsfehler für einen sehr großen Frequenzbereich verschwindet. Das geht beispielsweise aus der Gegenüberstellung der Integrationsverfahren in der Abbildung 3. 10-1 des genannten Buches hervor.

Die Ticksche Regel approximiert die Werte $J_n$ eines Integrals über die Funktion U mit den Funktionswerten $U_n$, die im gleichen Abstand eines Abtastintervalls $\Delta X$ als Daten erfaßt werden, durch

$$J_{n+1} - J_{n-1} = \Delta X(0{,}3584\,U_{n+1} + 1{,}2832\,U_n + 0{,}3584\,U_{n-1}).$$

Die Integration läßt sich frequenzmäßig noch weiter verbessern, wenn gemäß einer vorteilhaften Weiterbildung der Erfindung vor der Integration ein weiteres Bandpaßfilter verwendet wird, insbesondere eines, dessen Bandbreite auf die Integrationsschrittweite angepaßt und/oder so eingestellt ist, daß eine sehr langwellige Drift infolge des Offsetfehlers bei der Integration beschränkt wird.

Damit lassen sich sowohl Integrationsfehler, die durch hohe Frequenzanteile entstehen, als auch solche, die durch niedrige Frequenzanteile entstehen minimieren.

Integrationsfehler bei hohen Frequenzen treten insbesondere dann auf, wenn die Eckfrequenz des Filters, dargestellt durch die Filterfunktion f, in der Größenordnung des Reziprokwertes des Abtastintervalls $\Delta X$ liegt. Der frequenzabhängige Integrationsfehler kann dann durch eine weiteres Bandpaßfilter vor der Integration gedämpft werden.

Integrationsfehler bei niedrigen Frequenzen treten beispielsweise durch kleine Offsets in den empfangenen Signalen oder bestimmten Meßwerten $Y(X)$ auf. Diese können ebenfalls durch ein vor der Integration verwendetes Bandpaßfilter verringert werden.

Prinzipiell könnte man für das hochfrequente Filtern sowohl rekursive Filter als auch nichtrekursive Filter wählen. Wie aber schon von der Integration bekannt ist, die ebenfalls durch ein rekursives Filter darstellbar ist, können Fehler in den Anfangsbedingungen bei rekursiven Filtern beliebig weit anwachsen. Zur Verringerung derartiger Fehler wird gemäß einer vorteilhaften Weiterbildung für das Filter zur Gewinnung des Hochfrequenzanteils $Y_1(X)$ein nichtrekursives Filter gewählt. Ein möglicher Fehler des Filterns ergibt sich dann nur aus Fehlern in den Signalen oder Meßwerten eines begrenzten Bereichs des Parameters X und bleibt daher immer begrenzt.

Entsprechend den oben gegebenen Erläuterungen ist eine Vorrichrung zur Durchfürhung des Verfahrens gekennzeichnet durch zwei Filter zum Filtern eines hochfrequenten Anteils $Y_1(X)$ mit seiner Fouriertransformierten $y_1(\omega)$ und eines niederfrequenten Anteils $Y_2(X)$ mit seiner Fouriertransformierten $y_2(\omega)$ aus der Meßkurve oder dem Signalverlauf $Y(X)$ mit ihrer oder seiner Fouriertransformierten $y(\omega)$, deren Filtercharakteristiken in der Fourierdarstellung durch zwei Funktionen $f(\omega)$ und $g_{APPR}(\omega)$ als

$$y_1(\omega) = y(\omega)/g_{APPR}(\omega)$$

und

$$y_2(\omega) = f(\omega) \cdot y(\omega)$$

darstellbar sind, sowie durch eine Einrichtung zur Erzeugung eines Signals, das einer Funktion $H(X)$ proportional ist, mit der die Differentialgleichung

$$\sum_{k=0}^{N} a_k(-i)^k \frac{d^k}{dX^k} H(X) = Y_2(X),$$

gelöst wird, wobei die maßtechnischen Randbedingungen in den Integration konstanten erfaß sind und, bei der die Koeffizienten $\alpha_k$ und die maximal berücksichtigte Differentiation N aus einer genäherten Potenzreihe $p(\omega)$ für eine Funktion

$$z(\omega) = f(\omega)\frac{g_{APPR}(\omega) \cdot g(\omega)}{g_{APPR}(\omega) - g(\omega)}$$

mit

$$z(\omega) \cong p(\omega) = \sum_{k=0}^{N} a_k \omega^k$$

bestimmt sind, sowie durch eine Summiereinrichtung, die den hochfrequenten Anteil $Y_1(X)$ zu dem so erzeugten, der Lösung $H(X)$ der Differentialgleichung proportionalen Signal $\alpha$ addiert, daß sich eine korrigierte Meßkurve $Y_T'(X) = Y_1(X) + H(X)$ ergibt.

Gemäß der oben beim Verfahren schon angegebenen schaltungstechnischen Vereinfachung für verschiedene Probleme bei der Aufarbeitung von Meßwerten oder Signalen ist eine vorteilhafte Weiterbildung der erfindungsgemäßen Vorrichtung dadurch gekennzeichnet, daß die Einrichtung zur Erzeugung des der Lösung der Differentialgleichung proportionalen Signals mindestens N Zweige mit einer Multipliziereinrichtung, einem Integrator für n-fache Integration und einer weiteren Multipliziereinrichtung zur Erzeugung von den Integralausdrücken

$$A_{ln}(-i)^n e^{-i\omega_l X} \int .. \int e^{i\omega_l X} Y_2(X) dX^n$$

proportionalen Signalen aufweist, wobei die $\omega_l$ die N komplexen Nullstellen der Potenzreihe $p(\omega)$ bezeichnen und die Zahl der Integrationen n und die $A_{ln}$ der jeweilige Koeffizient eines Partialbruchs

$$\frac{A_{ln}}{(\omega - \omega_l)^n}$$

einer Partialbruchzerlegung von $1/p(\omega)$ sind, und in der Einrichtung eine Summiereinrichtung vorgesehen ist, welche die den Integralausdrücken proportionalen Signale aller Ausgänge der Zweige summiert. Die schaltungstechnischen Vorteile, die sich durch eine derartige Vorrichtung ergeben, wurden vorangehend schon in Zusammenhang mit dem erfindungsgemäßen Verfahren beschrieben.

Diese Weiterbildung bedingt schaltungstechnisch in einigen Fällen, z.B. wenn die Nullstellen $\omega_l$ der Potenzreihe $p(\omega)$ komplex werden, einen entsprechend großen Aufwand, den man allerdings, wie dargestellt, durch entsprechende Auswahl der Filterfunktion erniedrigen kann.

Zur Vereinfachung der Schaltung ist in einer vorzugsweisen Weiterbildung der Erfindung vorgesehen, daß die Einrichtung zur Erzeugung von einem der Lösung der Differentialgleichung proportionalen Signal mindestens N Zweige mit auf Poltermen bei der Frequenz $\omega_l$ abgestimmten Integrationsschaltungen enthält, die von dem niederfrequenten Anteil $Y_2(X)$ so angesteuert werden, daß deren Ausgang den Integralen

$$A_{ln} \, (-i)^n \, e^{-i\omega_l X} \int .. \int e^{i\omega_l X} \, Y_2 \, (X) \, dX^n$$

proportionale Signale abgibt, wobei die $\omega_l$ die N komplexen Nullstellen der Potenzreihe $p(\omega)$ bezeichnen und die Zahl der Integrationen n und der Koeffizient $A_{ln}$ jeweils die Potenz und der Koeffizient eines Partialbruchs

$$\frac{A_{ln}}{(\omega - \omega_l)^n}$$

einer Partialbruchzerlegung von $1/p(\omega)$ sind, und in der Einrichtung eine Summiereinrichtung vorgesehen ist, welche die den Integralausdrücken proportionalen Signale aller Ausgänge der Zweige summiert.

Die Multiplizierer und Integratoren werden dabei also durch spezielle Integrationsschaltungen ersetzt. Bei geeigneter Auslegung lassen sich auch komplexe $\omega_l$ ohne erhöhten Schaltungsaufwand realisieren. Der schaltungstechnische Aufbau derartiger Integrationsschaltungen wird in Zusammenhang mit den Ausführungsbeispielen näher beschrieben.

Wie vorstehend schon eingehend erörtert, lassen sich die notwendigen Filter, Oszillatoren, Multiplizierer und Summierer in verschiedenster Weise technisch realisieren. In einigen Fällen wird sogar eine mechanische Vorrichtung möglich sein.

Am einfachsten erfolgt die Realisierung des erfindungsgemäßen Verfahrens durch eine elektrisch arbeitende Vorrichtung, bei der die Meß- oder Signalwerte Y Ströme oder Spannungen sind oder als Ströme oder Spannungen gewandelt vorliegen und die Filter sowie die Einrichtung elektrische Schaltungen sind.

Der Aufwand ist bei einer elektrischen Schaltung besonders klein, weil viele Komponenten handelsüblich erhältlich sind. Der Preis ist wegen der Massenfertigung derartiger Bauelemente gering, und die nötigen Filter lassen sich häufig schon mit Pfennigbeträgen realisieren.

Besonders vorteilhaft ist eine elektrische Vorrichtung gemäß einer bevorzugten Weiterbildung der Erfindung, wenn diese als Prozessor mit einem Speicher und mit einer Eingabevorrichtung ausgebildet ist, über welche digital vorliegende oder digital gewandelte Meß- oder Signalwerte Y in einen Bereich des Speichers als Daten abgelegt werden, wobei ein Programm den Prozessor so steuert, daß zum Filtern der im Speicher abgelegten Daten digitale Filteralgorithmen angewendet werden und die Differentialgleichung numerisch gelöst wird.

Gemäß der Weiterbildung läßt sich eine Standardisierung dadurch erreichen, daß die Schaltung im wesentlichen ein Prozessor ist, bei dem verschiedene Filter durch digitale Filteralgorithmen ausgeführt sind.

Prozessoren in Form von Mikroprozessoren sind heute auch zum Preis unter hundert Mark zu realisieren. Allerdings steigt bei Prozessoren der Soffwareaufwand, Das spielt aber hier nur eine untergeordnete Rolle, da, wie beim Verfahren schon ausgeführt, bei Verwendung bestimmter Verfahrensschritten, die hier als Prozessorschritte verwirklicht werden, eine Softwareanpassung auf bestimmte Probleme leicht durch Anpassung der Anzahl der Variablen und der Konstanten erfolgen kann. Ein vielfältig einsetzbares Standardprogramm wird die Softwarekosten pro Vorrichtung entsprechend erniedrigen.

Gemäß einer vorteilhaften Weiterbildung der Erfindung ist mindestens eines der beiden Filter als neuronales Netzwerk ausgeführt.

Ausgangssignale eines neuronalen Netzwerks ergeben sich aus einer Matrixverknüpfung der Eingangswerte. Wie eingangs schon ausgeführt wurde, lassen sich die Faltungen und Entfaltungen auch durch Matrixmultiplikationen darstellen. Deshalb lassen sich auch neuronale Filter zur Entfaltung einsetzen.

Neuronale Netzwerke haben die Eigenschaft, daß die Koeffizienten der Matrix veränderbar sind und vom neuronalen Netzwerk "gelernt" werden können. Es ergibt sich also der Vorteil, daß zur Lösung der genannten Differentialgleichung ein Ein- oder Mehrfachintegrator eingesetzt wird und die Filterkoeffizienten für das Hochfrequenz- und Niederfrequenzfiltern vom Netzwerk über die Lernfunktion eingestellt werden. Dadurch ist das Filter auf praktisch alle Anwendungsfälle anpaßbar.

Bei dem eingangs genannten Problem des Echos beim Satellitenempfang ist die -Faltungsfunktion im allgemeinen nicht bekannt und standardmäßig vorgebbar, da sie stark von der Bebauung in der Nähe der Empfangsantenne abhängt. Eine Vorrichtung mit neuronalen Netzwerken als Filter kann aber leicht angepaßt werden, indem die jeweiligen Korrekturwerte von der Vorrichtung selbst gelernt werden. Als Signal zum "Lernen" eignet sich beispielsweise ein gesendeter Nadelimpuls, der praktisch alle Frequenzen gleichmäßig enthält. Beim Fernsehen läßt sich zum "Lernen" der richtigen Entfaltungsfunktion auch eine genormte Schwarzschulter verwenden.

Das erfindungsgemäße Verfahren und die erfindungsgemäße Vorrichtung lassen sich vor allem günstig bei der Rekonstruktion von Lagefehlern beim Gleisbau einsetzen. Dort hat die Fouriertransformierte der Faltungsfunktion aufgrund von Echosignalen bei bestimmten Meßwagenkonstruktionen Nullstellen bei kleinen Frequenzen, die eine Entfaltung über Inversion der Faltungsfunktion unmöglich machen. Da der Aufwand der Entfaltung gemäß dem dargestellten Verfahren mit einfachen Vorrichtungen durchführbar ist, lassen sich nun schnelle Aussagen über Gleislagefehler treffen. Vor allem berücksichtigt dies Verfahren auch die richtige Phasenlage der spektralen Komponenten der Gleislagefehler. Der Ort eines Gleislagefehlers läßt sich daher exakt angeben. Bei früheren Verfahren mußte eine Korrektur der Gleislage versuchsweise durchgeführt werden, und nachgemessen werden, wonach weiter korrigiert wurde u.s.w.. Solche iterativen Arbeitsweisen sind aufwendig und langwierig. Der Vorteil des erfindungsgemäßen Verfahrens und der Vorrichtung liegt deshalb auch in der vereinfachten Arbeitsweise bei der Gleiskorrektur, die Zeit und Geld spart.

Das erfindungsgemäße Verfahren und die erfindungsgemäße Vorrichtung werden im folgenden anhand der Zeichnung beispielhaft noch näher beschrieben. Es zeigen:

Fig. 1   eine erfindungsgemäße Vorrichtung zur Signalkorrektur;

Fig. 2   eine schematisch dargestellte Ausführungsform einer erfindungsgemäßen Einrichtung zur schaltungstechnischen Erzeugung der Lösung der Differentialgleichung für H(X), die in der Vorrichtung nach Fig. 1 einsetzbar ist;

Fig. 3   verschiedene Integrationsschaltungen zur Ausführung von Integralen zum Einsatz bei der Einrichtung aus Fig. 1;

Fig.4   eine erfindungsgemäße Vorrichtung zur Erfassung von Gleislagefehlern und zur Korrektur der Meßwerte mittels numerischer Auswertung innerhalb eines Prozessors;

Fig. 5   das Prinzip der Wandersehne bei der Erfassung von Gleislagefehlern mittels Dreipunktabtastung und die daraus folgende Impulsantwort;

Fig. 6   verschiedene Diagramme zur Erläuterung der Wirkung des beim erfindungsgemäßen Verfahren verwendeten Hochfrequenzfilters: a) genäherte Entfaltungsfunktion, b) rekonstruierter Meßwert einer Diracfunktion unter Anwendung der genäherten Entfaltungsfunktion, c) Rekonstruktion einer durch die Faltungsfunktion veränderten Sprungfunktion mittels der genäherten Entfaltungsfunktion;

Fig. 7   die Amplitude und Phase der Übertragungsfunktion g(ω) bei der Dreipunktabtastung;

Fig. 8   die Amplitude und Phase der Rekonstruktion mit dem erfindungsgemäßen Verfahren in einer Vorrichtung nach Fig. 4;

Fig. 9   eine schematische Darstellung des Mauzinmeßwagens der französischen Eisenbahn.

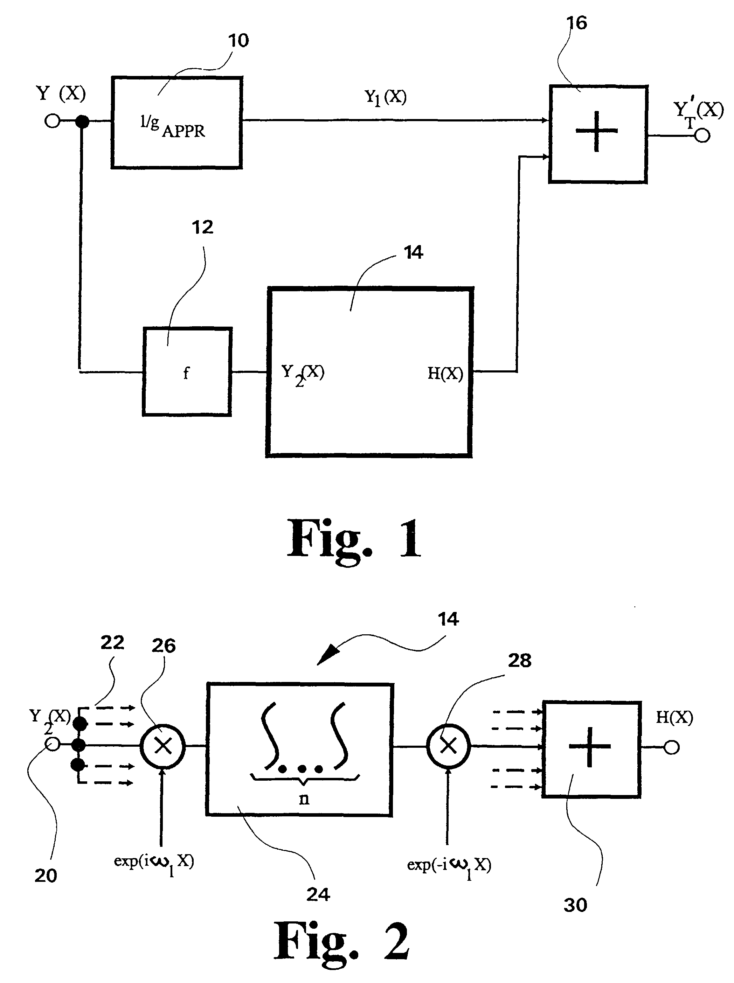

Das erfindungsgemäße Verfahren wird in der Fig. 1 anhand einer Vorrichtung zur Korrektur von Signalverläufen verdeutlicht. Das Ausführungsbeispiel betrifft elektrische Signale, die am Eingang der Vorrichtung als Spannungen Y anliegen. Der eingangs genannte Parameter X ist hier die Zeit, so daß die Funktion Y(X) den zeitlich empfangenen Spannungsverlauf darstellt.

Signale werden im allgemeinen nicht unverändert von einem Sender zu einem Empfänger übertragen. Hohe Frequenzen werden meist durch Leitungsinduktivitäten und Leitungskapazitäten gedämpft und phasenverschoben, so daß gesendete Signale in der Nähe einer Grenzfrequenz nur verfälscht empfangen werden. Weiter können, insbesondere bei der Übertragung mittels Antennen, Reflexionen auftreten, die beispielsweise zu Echosignalen führen.

Die zumindest genäherte Rückgewinnung von senderseitigen Signalen $Y_T(X)$ kann durch das erfindungsgemäße Verfahren durchgeführt werden. Das erlaubt Signalübertragung sogar in der Nähe der Grenzfrequenz, wodurch beispielsweise bei der Datenübertragung eine höhere Datenrate auf den gleichen Leitungen möglich wird.

Echosignale treten ebenfalls als Störungen, insbesondere beim Telefonieren nach Übersee, auf, die bisher nur durch zeitweises Stummschalten der Übertragungsstrecke beseitigt werden konnten. Außerdem sind Signalechos beispielsweise als Schattenbild beim Fernsehen zu beobachten. Eine Korrektur von Echosignalen mit dem Verfahren erhöht also die Bildqualität.

Zur Erläuterung des Verfahrens und der beispielhaften Auslegung einer Vorrichtung gemäß Fig. 1 wird im folgenden eine einfache Leitung mit ohmschen und kapazitiven Anteilen betrachtet. Verzerrungen aufgrund von Leitungskapazitäten lassen sich beim erfindungsgemäßen Verfahren mit Standardbauelementen, wie Kondensatoren, Induktivitäten und Widerständen, korrigieren.

Die Ersatzschaltung für eine Leitung ist im wesentlichen ein Tiefpaß mit einer Grenzfrequenz $\omega_g$ oberhalb der Sinuswellen nur noch stark gedämpft und phasenverschoben übertragen werden. Zur weiteren Vereinfachung wird angenommen, daß die Induktivität der Leitung wesentlich kleiner als $R/\omega_g$ ist, wobei R den Leitungswiderstand bezeichnet, so daß bei der beispielhaften Beschreibung des Ausführungsbeispiels induktive Anteile nicht berücksichtigt werden müssen.

Bei der Übertragung eines Signals muß sich die Kapazität der Leitung erst laden, so daß die Anstiegsflanke eines eingangsseitigen Rechteckimpulses am Ausgang der Leitung wesentlich langsamer ansteigt. Bei der Rückflanke des Rechteckimpulses, ist die Kapazität noch geladen, so daß am Ausgang der Leitung, am Signalempfänger, noch Spannung anliegt, wenn sendeseitig der Rechteckimpuls längst beendet ist. Der empfangene Signalverlauf Y(X) enthält damit also nicht nur die Information des aktuell gesendeten Signals $Y_T$(X) sondern auch Beiträge von vorherigen Zeitpunkten, die als Ladung in der Kapazität der Übertragungsleitung gespeichert wurden.

Damit ist der in Gleichung 1.0 ausgedrückte Zusammenhang gegeben, wobei die Faltungsfunktion G durch die physikalischen Eigenschaften der Leitung bestimmt ist.

Die Funktion G läßt sich direkt messen, indem am Eingang der Leitung ein Nadelimpuls eingegeben und das Ausgangssignal bestimmt wird. Eine andere Möglichkeit besteht darin, die Leitung mit Sinusschwingungen verschiedener Frequenzen $\omega$ eingangsseitig zu beaufschlagen und ausgangsseitig Phase und Dämpfung der Sinusschwingung zu ermitteln. Dann macht man von der Fourierdarstellung gemäß Gleichung 1.1 Gebrauch und bestimmt die Funktion $g(\omega)$, die üblicherweise Übertragungsfunktion genannt wird.

Bei dem genannten vereinfachten Beispiel einer Signalverzerrung durch eine Leitung mit ohmschen und kapazitiven Beiträgen ist die Übertragungsfunktion:

$$g(\omega) = \frac{1}{1 + i\dfrac{\omega}{\omega_g}}.$$

Durch die Übertragungsfunktion werden also hohe Frequenzen mit $1/\omega$ gedämpft.

Den gesendeten Signalverlauf könnte man rekonstruieren, indem man den empfangenen Signalverlauf mit $1/g(\omega)$ frequenzmäßig wichtet, bzw. gemäß der obigen Darstellung, eine Entfaltung mit der Fourierrücktransformierten von $1/g(\omega)$ als Entfaltungsfunktion $G^{-1}$(X) auf das Signal anwendet. Eine Inversion im gesamten Frequenzbereich ist aber unmöglich, da $1/g(\omega)$ nach oben nicht beschränkt ist. Man kann jedoch die Fouriertransformierte in einem begrenzten Frequenzbereich $|\omega| < \omega_A > \omega_g$ mit einer Abschneidefrequenz $\omega_A$ bilden, um die Frequenzbegrenzung für die Signalübertragung bis zur Abschneidefrequenz hinauszuschieben.

Eine Entfaltung ist bei schnellen Signalen numerisch nicht mehr schnell genug durchführbar, so daß man zur angenäherten Rückgewinnung des gesendeten Signals günstiger das erfindungsgemäße Verfahren einsetzt.

Die dazu nötigen schaltungstechnischen Komponenten sind in Fig. 1 gezeigt. Der eingangsseitig empfangene Signalverlauf Y(X) wird auf ein Hochfrequenzfilter 10 gegeben, welches die hohen Frequenzen so anhebt, daß eine angenäherte Entfaltung stattfindet. Außerdem gelangt das Eingangssignal auf ein Niederfrequenzfilter 12, dessen Ausgangssignal $Y_2$(X) an eine schaltungstechnische Einrichtung 14 zur Lösung H(X) der Differentialgleichung 3.0 eingegeben wird. Die Einrichtung bildet der Lösung H(X) proportionale Signalverläufe, die zu einem Ausgangssignal $Y_1$(X) des Hochfrequenzfilters 10 über einen Summierer 16 zur Rekonstruktion des korrigierten Signalverlaufs $Y_T$'(X) addiert werden.

Die Auslegung der Schaltung wird im folgenden verdeutlicht. Um die Leitungsdämpfung bei hohen Frequenzen zu kompensieren muß das empfangene Signal mit $i\omega/\omega g$ multipliziert werden. Dies kann man dadurch erreichen, daß das Hochfrequenzfilter als Hochpaß mit einer Grenzfrequenz $\omega_A >> \omega_g$ ausgeführt wird. Dann wird das Signal zwar nur bis zu einer bestimmten hohen Frequenz $\omega_A$ korrigiert, wie bei den vorherigen Ausführungen über die Entfaltungsfunktion schon deutlich wurde. Eine Einschränkung der Entfaltung bis zu Frequenzen $\omega_A$ zur Korrektur ist aber hier auch deshalb sinnvoll, da ein Anheben zu großer Frequenzen auch zu einer Anhebung des Rauschens ihren würde.

Ein Hochpaß läßt sich durch folgendes Frequenzverhalten charakterisieren:

$$\frac{i\omega/\omega_A}{1 + i\omega/\omega_A}.$$

Das lineare Verhalten bei Frequenzen $\omega \ll \omega_A$ ist aus dem Ausdruck direkt ablesbar. Allerdings ist das Ausgangssignal des Hochpasses zur Korrektur der Fouriertransformierten $y(\omega)$ des Signalverlaufs um den Faktor $\omega_A/\omega_g$ zu klein. Deshalb ist in dem Hochfrequenzfilter 10 noch ein Verstärker mit dem entsprechenden Verstärkungsfaktor vorgesehen. Damit ergibt sich eine angenäherte Entfaltung bei großen Frequenzen, die durch die Funktion

$$\frac{1}{g_{APPR}(\omega)} = \frac{i\omega/\omega_g}{1 + i\omega/\omega_A}$$

beschrieben wird. Mit dieser Wahl der genäherten Entfaltungsfunktion wird die Korrekturfunktion bei niedrigen Frequenzen

$$\frac{f(\omega)}{z(\omega)} = 1 + i\frac{\omega}{\omega_g} - \frac{i\omega/\omega_g}{1 + i\omega/\omega_A},$$

so daß die zur Korrektur benötigte Funktion z über die Beziehung

$$z(\omega) = \frac{1 + i\omega/\omega_A}{\left(1 + i\omega/\omega_g\right) \cdot \left(1 + i\omega/\omega_A\right) - i\omega/\omega_g} \cdot f(\omega)$$

gewonnen wird. Diese Gleichung läßt sich auch darstellen als:

$$z(\omega) = \frac{f(\omega)}{1 + i\omega/\omega_g \left[1 - \frac{1}{1 + i\omega/\omega_A}\right]}$$

Im Nenner steht für $\omega \ll \omega_A$ in erster Näherung der Ausdruck $1 - \frac{\omega^2}{\omega_g \omega_A}$, dessen Kehrwert bei der genannten Näherung eine Potenzreihe $1 + \frac{\omega^2}{\omega_g \omega_A}$ zweiter Ordnung ergibt.

In diesem Ausführungsbeispiel läßt sich also schon bei der Wahl $f(\omega)=1$ für z eine einfache genäherte Potenzreihe $p(\omega)$ angeben. Dann läßt das Niederfrequenzfilter 12 hier prinzipiell alle Frequenzen gleichermaßen durch. Zur Verringerung des Rauschens ist es jedoch vorteilhaft, hier ebenfalls den Frequenzbereich nach oben zu begrenzen. Die Funktion f sollte allerdings, damit die genannte einfache Näherung verwendbar bleibt, bis zu einer Frequenz $\omega_A$ möglichst flach verlaufen. Die Grenzfrequenz des Niederfrequenzfilters 12 beträgt dann zweckmäßigerweise ein Vielfaches der Abschneidefrequenz.

Besonders zur Rauschverminderung wäre ein flacher Verlauf, der bei einer Eckfrequenz $\omega_A$ abrupt abbricht, wünschenswert, damit höhere Potenzen von $\omega$ in der Näherung nur unwesentlich beitragen. Ein derartiges Frequenzverhalten ist von stark gegengekoppelten Verstärkern bekannt.

Verstärker werden in der Schaltung, beispielsweise in der Einrichtung 14, wie später noch dargestellt wird, eingesetzt, so daß man das Abschneiden bei hohen Frequenzen schon allein mit deren Hilfe durchführen kann. Deshalb führt man die Entfaltung günstig so durch, daß die Frequenz $\omega_A$ auf den Wert der Grenzfrequenz der Verstärker festgelegt wird. Zum Filtern mit der Funktion $f(\omega)$ ist dann kein gesondertes Filter erforderlich, da dessen Aufgabe von den Verstärkern in der Einrichtung 14 übernommen wird, so daß sich dann $y_2=y_1$ ergibt.

Die dann beim Verfahren auftretende, die Funktion z nähernde Potenzreihe

$$p(\omega) = 1 + \frac{\omega^2}{\omega_A \omega_g}$$

führt auf die durch die Einrichtung 14 zu lösende Differentialgleichung nach Gleichung 3.0 :

EP 0 697 672 B1

$$-\frac{1}{\omega_A \omega_g} \cdot \frac{d^2}{dX^2} H(X) + H(X) = Y_2(X)$$

Die Einrichtung 14 kann also in bekannter Weise als Analogrechner zur Lösung von Differentialgleichungen ausgeführt werden, dessen Signalverlauf am Ausgang die Lösung H(X) repräsentiert und dessen Eingangsgröße $Y_2$ (X) ist. Eine derartige Schaltung wird weiter unten noch in Verbindung mit Fig. 3 angegeben.

Das Beispiel macht deutlich, daß Signalverfälschungen mit Hilfe von Schaltungen nach Fig. 1 korrigiert werden können. Bei komplexeren Problemen können bei der Näherung der Funktion z durch eine Potenzreihe p jedoch sehr hohe Potenzen auftreten, die eine sehr aufwendige Schaltung für die Einrichtung 14 nötig machen können.

Eine Standardisierung der Einrichtung 14 für beliebig komplexe Probleme der Signalrückgewinnung wird aber aufgrund einer Partialbruchzerlegung möglich, deren schaltungstechnische Behandlung in Fig. 2 angedeutet ist.

Wie eingangs schon ausgeführt wurde, läßt sich die Lösung der Differentialgleichung 3.0 durch Partialbruchzerlegung von 1/p($\omega$) in Integrale mit Polen in der Fourierdarstellung bei den Nullstellen der Potenzreihe p($\omega$) aufspalten, deren Lösungen entsprechend der Partialbruchsumme anschließend summiert werden. Eine solche Schaltung für die Einrichtung 14 der Fig. 1 ist in Fig. 2 gezeigt.

Das am Eingang 20 anliegende Signal $Y_2$(X) wird entsprechend der Anzahl der zu berücksichtigenden Partialbrüche in mehrere Zweige 22 aufgeteilt. In jedem Zweig werden Integrationen durch einen Mehrfachintegrator 24 und Multiplikationen durch zwei Multiplizierer 26 und 28 durchgeführt, wodurch die Gleichung 4.0 schaltungstechnisch nachgebildet ist. Die Ausgänge der Zweige werden in der nachfolgenden Summiereinrichtung 30 entsprechend den Koeffizienten der Partialbruchzerlegung gewichtet summiert.

Die Fig. 2 ist dabei nur als Schaltschema zu verstehen. Da es sich um komplexe Zahlen handelt, werden bei jedem Multiplizierer 26 zwei Produkte erzeugt, für eine Sinus und eine Cosinusschwingung, so daß anstelle des einen schematisch gezeichneten Multiplizierers 28 vier Produkte gebildet werden müssen, die anschließend phasenrichtig addiert werden.

Die Multiplikationen mit Sinus- und Kosinusschwingungen und die Multiplizierer 26 und 28 ist auch nur dann möglich, wenn die Frequenzen $\omega_1$ identisch mit Nullstellen der Potenzreihe p($\omega$) sind. Das kann man im allgemeinen dadurch erreichen, daß man Nullstellen in der Funktion f($\omega$) vorgibt, indem im Niederfrequenzfilter 12 Saugkreise für bestimmte Frequenzen $\omega_1$ vorgesehen sind, oder dieses mittels mehrerer parallelgeschaltete Bandpässe mit Phasendrehungen um 180° bei den Frequenzen $\omega_1$ aufgebaut wird.

Andernfalls sind die Nullstellen komplex, wobei sich der Imaginärteil von $\omega_1$ bei der Multiplikation als Exponentialfunktion auswirkt. Derartige Funktionen kann man ebenfalls mit einem Funktionsgenerator erzeugen. Die Exponentialfunktionen müssen aber zur Vermeidung von Divergenzen zeitweilig zurückgesetzt werden.

Schaltungstechnisch ist dann die folgende Beziehung zu berücksichtigen:

$$e^{AX} \int \dots \int e^{-AX} C(X) dX^n = e^{AX-B} \int \dots \int e^{-AX+B} C(X) dX^n,$$

die unabhängig von der Wahl der Funktion C und dem Parameter A gültig ist. Die Beziehung sagt aus, daß der Exponent bei Anwachsen des Integrals über ungewollte Grenzen mit einer geeigneten Zahl B zurückgesetzt werden kann.

Der Aufwand einer Schaltung nach Fig. 2 wird dann möglicherweise, obwohl sie für sehr komplexe Probleme standardisiert werden kann, sehr hoch werden. Deswegen ist es für bestimmte Nullstellen günstiger, Integrationsschaltungen in den Zweigen vorzusehen, die in Fig. 3 beispielhaft gezeigt sind, wobei aber das Prinzip der Fig. 2 zum Bau einer standardisierten Einrichtung mit verschiedenen Zweigen entsprechend einer Partialbruchzerlegung von 1/p($\omega$) beibehalten wird.

Die in Fig. 3 in den Beispielen a, b, c und d enthalten jeweils eine Folge von zwei hintereinander geschalteten invertierenden Verstärkern 32 und 34. Alle in der Fig. 3 gezeichneten Widerstände haben den gleichen Wert R, so daß die Differenzverstärker 32 und 34 beide die Verstärkung 1 aufweisen.

Der jeweilige Verstärker 32, der vom Eingang 36 ein Signal erhält, addiert auch auf das Eingangssignal ein Ausgangssignal eines dritten invertierenden Verstärkers 38, der mit Hilfe von Kondensatoren der Kapazität C bzw. Spulen der Induktivität L als Differenzierglied geschaltet ist. Das Differenzierglied wird von einem dem Ausgangssignal proportionalen Signal gleicher oder umgekehrter Polarität angesteuert. Der Verstärker 32 als Summierer regelt also das Ausgangssignal der Änderung des differenzierenden Verstärkers 38 nach, so daß die Schaltungen als Integratoren arbeiten.

Die Lösung der durch die Integratoren gelösten Differentialgleichungen läßt sich direkt aus den abgebildeten Schaltungen ablesen. Zur Kennzeichnung des Integrationsverhaltens wird für e($\omega$) die Fouriertransformierte des Eingangssignals E(X) sowie für a($\omega$) die Fouriertransformierte des Ausgangssignals A(X) gesetzt. Zur Ermittlung der einzelnen Integrationen bei den Schaltungen a, b, c und d wird die Summenbildung am Verstärker 32 betrachtet:

17

Schaltung nach Fig. 3a:

$$e(\omega) + i\omega RCa(\omega) = a(\omega)$$

$$a(\omega) = \frac{e(\omega)}{1 - i\omega RC}$$

Schaltung nach Fig. 3b:

$$e(\omega) + i\omega RCa(\omega) = a(\omega)$$

$$a(\omega) = \frac{e(\omega)}{1 + i\omega RC}$$

Schaltung nach Fig. 3c:

$$e(\omega) - \omega^2 LCa(\omega) = a(\omega)$$

$$a(\omega) = \frac{e(\omega)}{1 + \omega^2 LC}$$

Schaltung nach Fig. 3d:

$$e(\omega) + \omega^2 LCa(\omega) = a(\omega)$$

$$a(\omega) = \frac{e(\omega)}{1 - \omega^2 LC}$$

Die Schaltungen nach 3a und 3b bilden also jeweils das Ausgangssignal entsprechend einem Partialbruch mit rein imaginärer Nullstelle im Nenner nach, das bei Fig. 2 bei Ausbildung zur Bestimmung des Integralausdrucks 4.0 nur mit hohem Aufwand möglich gewesen wäre. Bei höheren Potenzen n im Partialbruch

$$\frac{1}{(\omega - \omega_l)^n}$$

können derartige Schaltungen auch hintereinander geschaltet werden.

Die Figuren 3d und c, zeigen eine verwendbare Alternative, wenn zwei Partialbrüche mit gleichen Koeffizienten aber entgegengesetztem Vorzeichen in der den Pol bestimmenden Frequenz $\omega_1$ der Partialbruchzerlegung auftreten. Die Schaltung 3c ermöglicht die Ausführung von Integrationen bei rein imaginären Nullstellen, während die Schaltung 3d reelle Nullstellen behandelt. Mit der Schaltung von 3c läßt sich somit die Lösung der Differentialgleichung für das angegeben Beispiel der Rückgewinnung eines Signals, das durch eine ohmsch/kapazitive Leitung gedämpft ist, schaltungstechnisch nachbilden.

Die Schaltung 3d zeigt einen auf der Frequenz $\omega_l = \sqrt{LC}$ schwingenden Oszillator, der vom Eingangssignal angeregt wird. Er liefert das gleiche Ausgangssignal, wie zwei Zweige der Schaltung von Fig. 2, jedoch ohne den Aufwand von Multiplizieren 26 und 28 und zusätzlichen Integratoren und stellt für viele Fälle, eine wesentliche Vereinfachung dar.

Die Schaltungen der Fig. 3 zeigen beispielhaft, wie mit verschiedenen passiven Baugruppen und einigen Operationsverstärkern die verschiedenen bei der Lösung der Differentialgleichung auftretende Partialbrüche schaltungstechnisch nachgebildet werden können. Bei entsprechender Beschaltung mit Kombinationen von Spulen, Kondensatoren und Widerständen lassen sich in gleicher Weise auch andere Einrichtungen zur Lösung der Differentialgleichung 3.0 aufbauen.

Wie eingangs erwähnt, kann man das Verfahren und die Vorrichtungen auch zur Korrektur gegen Echosignale, die durch Reflektionen in Leitungen und Antennen entstehen können, einsetzen. Die entsprechende Faltungsfunktion läßt sich dabei allgemein darstellen als:

$$G(X) = \delta(X) + V(X - T)$$

Der Ansatz beschreibt im ersten Term, die Reproduktion des gesendeten Signals. Der zweite Term berücksichtigt das Auftreten eines Echos nach einer Laufzeit T, die Funktion V enthält dabei die Verzerrung des Echos.

Man kann nun die Funktion $G_{APPR}(X)$ zur Korrektur des Echos und die Differentialgleichung zur Korrektur der Verzerrungen ansetzen:

$$G_{APPR}^{-1} = \delta(X) - D \cdot \delta(X - T)$$

mit

$$D = \int_{-\infty}^{+\infty} V(X) dX \ ,$$

wobei D die Dämpfung des Echos beschreibt.

Die angegebene approximative Entfaltungsfunktion wird in einem Hochfrequenzfilter 10 schaltungstechnisch günstiger mit Hilfe einer Verzögerungsleitung nachgebildet als mit Bauelementen wie Kondensatoren, Spulen und Widerständen. Dieses Beispiel zeigt, daß beim Verfahren nicht nur phasenverschiebende Bauelemente, sondern auch Verzögerungsleitungen, die um feste Zeiten T verschieben, vorteilhaft eingesetzt werden können.

Das folgende Ausführungsbeispiel zeigt die Korrektur von Echosignalen und die Verwendung digitaler Filter zur Durchführung des Verfahrens beispielhaft. Es betrifft die Bestimmung von Lagefehlern bei Bahngleisen aus geometrischen Relativmessungen.

Zur Korrektur von Lagefehlern kommt es vor allem auf eine genaue meßtechnische Erfassung der Gleislage an, die mit Hilfe des Verfahrens vorteilhaft rekonstruiert werden kann.

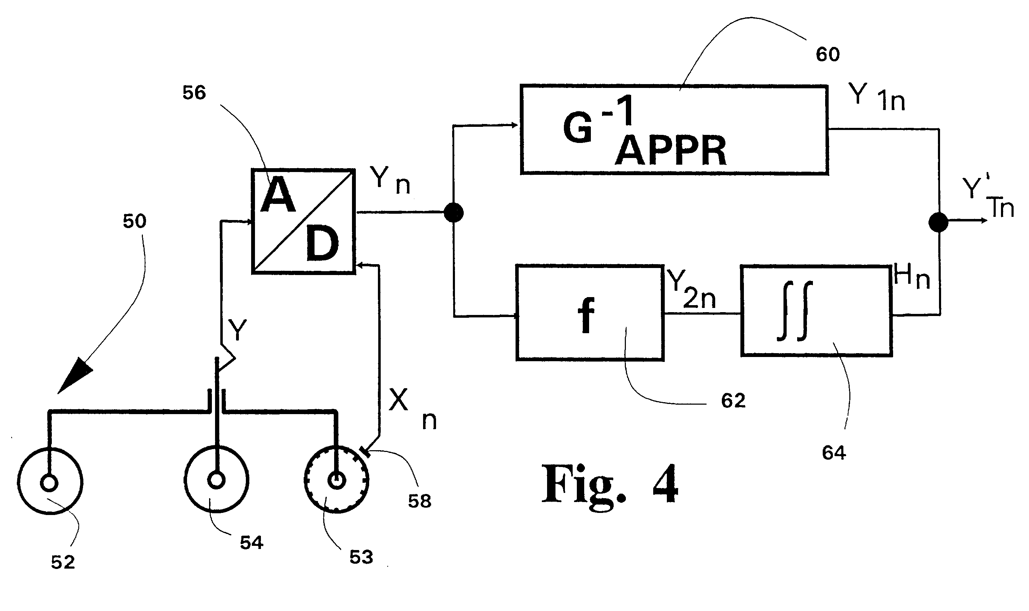

Fig. 4 zeigt den Aufbau einer entsprechenden Vorrichtung zur meßtechnischen Bestimmung der Lagefehler. Zur Erfassung der Gleislage dient ein Meßwagen 50, der auf Rädern 52 und 53 das Gleis abfährt. Zwischen den Rädern wird die Abweichung des Gleises von einer durch die Räder 52 und 53 gebildeten Geraden mit Hilfe eines Meßfühlers 54 erfaßt. Prinzipiell wird eine Sehne über die Gleiskrümmung vermessen, weshalb man das Verfahren auch Wandersehnenmessung nennt.

Die Gleislage wird aber nicht direkt ermittelt, sondern es entstehen sogenannte Echosignale. Dies erkennt man daraus, daß der Meßfühler 54 nicht nur ein Signal abgibt, wenn er eine Erhöhung abtastet, sondern auch dann, wenn eines der Räder 52 oder 53 über diese fährt, da diese die Meßbasis aufspannen. Bei der Anwendung des eingangs geschilderten Verfahrens wird in diesem Ausführungsbeispiel ein Prozessor in einem Digitalrechner verwendet. Zur Datenverarbeitung werden die von dem Meßfühler 54 aufgenommenen Meßwerte mittels eines Analog-Digitalwandlers 56 digital gewandelt und in einem Speicher eines Digitalrechners abgelegt. Im Anwendungsbeispiel ist der Speicher als Ringspeicher programmiert. Die Digitalisierung aufeinanderfolgender Meßwerte erfolgt in gleichen vom Wagen befahrenen Wegstrecken. Dafür ist ein Impuls- oder Inkrementgeber 58 vorgesehen, der den Analog-Digitalwandler 56 nach gleichen durchfahrenen Weginkrementen $\Delta X$ zur Wandlung der Daten ansteuert und den Digitalrechner zur Übernahme der gewandelten Daten veranlaßt.

Bei dem Verfahren erfolgt das Filtern mit den in Fig. 4 gezeigten digitalen Filtern 60, 62 und 64, deren Filtereigenschaften in diesem Beispiel durch Programmschritte definiert sind.

Das Filter 60 führt eine näherungsweise Entfaltung für eine approximative Faltungsfunktion $G_{APPR}(X)$ durch. Das Filter 62 enthält den Tiefpaß für die im Verfahren verwendete Funktion f. Die Lösung der Differentialgleichung wird mittels des Filters 64 gewonnen, denn, wie aus der Theorie digitaler Filter folgt, lassen sich auch Integrationen mit einem rekursiven Filteralgorithmus beschreiben.

Das Ergebnis des Filters 64 wird dem Ergebnis der approximativen Entfaltung des Filters 60 als Korrektur zugeschlagen und bildet die korrigierte Meßkurve, mit der anschließend die Gleislage ausgerichtet werden kann.

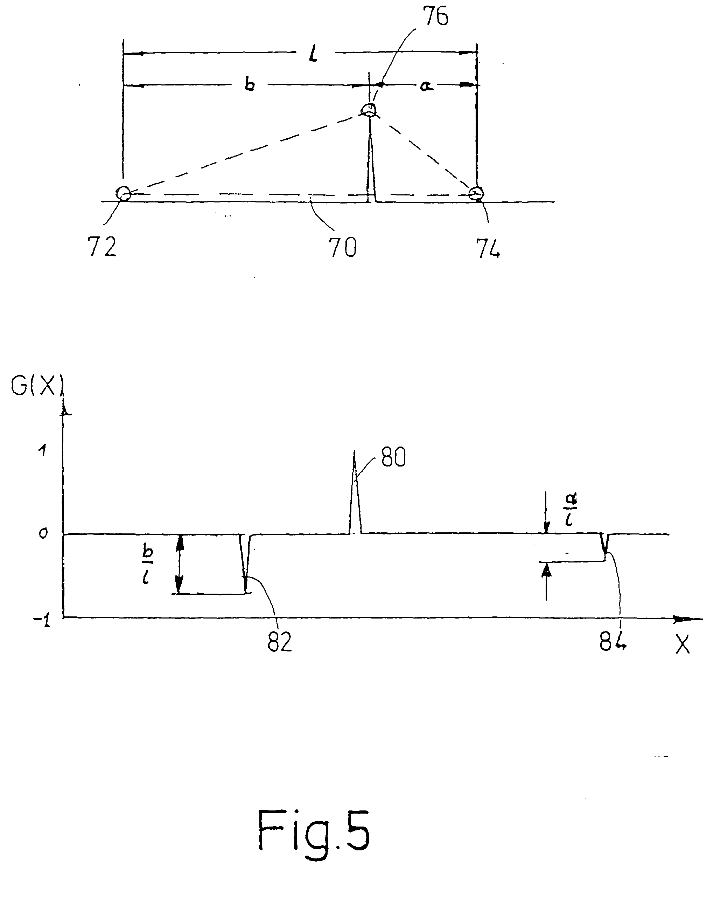

Die durch die Faltung entstehenden Probleme werden aus Fig. 5 deutlich. Der obere Teil der Fig. 5 stellt die Meßanordnung schematisch als Sehne 70 mit Endpunkten 72 und 74 dar. Die Lageabweichung eines Meßpunktes 76 wird durch den Meßfühler 54 bestimmt. Das Diagramm im unteren Teil der Fig. 5 deutet schematisch die daraus resultierende Faltungsfunktion G an.

Die Messung erfolgt über eine Sehne der Länge 1, wobei der Meßfühler 54 im Abstand a bzw. b von den Endpunkten 72 und 74 angeordnet ist. Die daraus sich ergebende Faltungsfunktion G ist dann näherungsweise darstellbar als:

$$G(X) = \delta(X) - b/l \cdot \delta(X + a) - a/l \cdot \delta(X - b)$$

Der erste Term beschreibt dabei das gewünschte Signal 80, die folgenden beiden Terme stellen unerwünschte Echosignale 82 und 84 dar, die durch Abtastung der Gleislage mit den Rädern 52 und 53 erzeugt werden. Die jeweilige Höhe der Echosignale 82 und 84 läßt sich durch Anwendung des zweiten Strahlensatzes aus dem oberen Teil der Fig. 5 ablesen.

Das Integral über G(X) verschwindet und die Fouriertransformierte g weist deshalb bei der Frequenz Null eine Nullstelle auf. Deshalb ist eine Entfaltung über eine Inversion der Faltungsfunktion nicht möglich.

Eine nichtinvertierbare Faltungsfunktion ist bei dem Wandersehnenverfahren prinzipiell nicht zu umgehen. Man kann zwar durch geschickte Zusammenschaltung mehrerer Meßwagen, wie bei einem Meßwagen der französischen Eisenbahn, die Amplitude der Echosignale verringern, was aber eine Erhöhung der Anzahl der Echosignale zur Folge hat, so daß auch hier wieder das Integral über G(X) verschwindet. Die Funktion ist im eingangs genannten Artikel von P. N. Bashkaran Nair angegeben. Für den im Artikel beschriebenen Meßwagen ist allerdings ein großer Aufwand von 8 Achsen nötig, der mit dem eingangs erläuterten Verfahren entfällt.

Aus der dargestellten Entfaltungsfunktion lassen sich noch weitere Eigenschaften entnehmen, die bei der Auswahl der für das Verfahren zweckmäßigen Filterfunktionen wesentlich werden:

Die Auswertung des Integrals 1.0 für die Meßwerte Y in Abhängigkeit der wahren Abweichungen $Y_T$ von einer Geraden ergibt:

$$Y(X) = Y_T(X) - \frac{b}{l} Y_T(X + a) - \frac{a}{l} Y_T(X - b)$$

Diese Umformung zeigt direkt, wie sich die Meßwerte Y auch mit Hilfe einer Matrixmultiplikation aus den Abweichungen $Y_T$ darstellen lassen. Die Matrix ist aber nicht invertierbar, da deren Determinante Null ergibt.

Weiter läßt sich aus einer Taylorentwicklung der zweiten und dritten, die Echosignale 82 und 84 beschreibenden Terme herleiten, daß das erste nicht verschwindende Glied für Y zweite Ableitungen von $Y_T$ enthält:

$$Y(X) \approx Y_T(X) - \frac{b}{l}\left[ Y_T(X) + a\frac{d}{dX}Y_T(X) + \frac{a^2}{2}\frac{d^2}{dX^2}Y_T(X) \right]$$
$$- \frac{a}{l}\left[ Y_T(X) - b\frac{d}{dX}Y_T(X) + \frac{b^2}{2}\frac{d^2}{dX^2}Y_T(X) \right] = -\frac{ab}{2}\frac{d^2}{dX^2}Y_T(X)$$

Für sehr große Abstände X lassen sich die Abweichungen $Y_T$ also durch zweifache Integration der Meßwerte Y darstellen. Bei geeigneter Wahl der Funktionen $g_{APPR}(\omega)$ und $f(\omega)$ sollte sich daher die Potenzreihe $p(\omega)$ allein durch $\omega^2$ ausdrücken lassen, so daß sich das Integral 4.0 auf eine einfache Zweifachintegration reduziert.

Der Wert der Potenzreihe $p(0)$ verschwindet unabhängig von dieser Wahl, da die Potenzreihe proportional zu g definiert ist. Bei der Auswahl der approximativen Faltungsfunktion und der Filterfunktion f sollte aber darauf geachtet werden, daß $z(\omega) = z(-\omega)$ wird, so daß durch unglückliche Wahl von $g(\omega)$ neue Terme proportional $\omega$ nicht erzeugt werden.

Unter dieser Voraussetzung verschwinden auch alle ungeraden Ableitungen, so daß mit der eben ausgeführten Taylorentwicklung schon durch eine Zweifachintegration eine hochgenaue Rekonstruktion der Gleislage für große Abstände X aus den Meßwerten Y entnommen werden kann, denn auch dritte Ableitungen liefern dann keinen Beitrag.

Zur Ermittlung der Filterfunktionen wird die Nebenbedingung gefordert, daß das die Integrationen ausführende Filter 64 eine einfache Zweifachintegration entsprechend der oben angegebenen, durch Taylorentwicklung gewonnenen Beziehung ausführt.

Das Hauptproblem beim Finden der approximativen Entfaltungsfunktion ist hier das Auftreten der Nullstelle von g bei kleinen Frequenzen, die darauf beruht, daß das Integral der Faltungsfunktion verschwindet.

Beim Ausführungsbeispiel wurde das dadurch gelöst, daß die Funktion $G_{APPR}(X)$ aus der Faltungsfunktion $G(X)$ durch Multiplikation mit einer gegen große X abfallenden Fensterfunktion $W(X)$ gewonnen wird. Die Fensterfunktion W reproduziert bei Festlegung $W(0)=1$ den Funktionswert bei $X=0$. Deshalb zeigt die approximative Faltungsfunktion für sehr hohe Frequenzen ein ähnliches Verhalten wie die Faltungsfunktion des Meßwagens 50. Sie dämpft allerdings die Funktion bei größeren X, so daß die Echosignale 82 und 84 nicht mehr so stark beitragen. Deshalb wird $g_{APPR}$ bei kleinen Frequenzen verschieden von Null und ist für eine genäherte Entfaltung invertierbar.

Die folgenden Ausführungen beziehen sich auf einen Meßwagen 50 mit einer vorlaufenden Achse 53 im Abstand a von 2,6 m und einer nachlaufenden Achse 52 im Abstand b von 6,0 m von dem Meßaufnehmer. Die Meßdaten werden im Abstand von 0,5m aufgenommen.

Die eingangs erwähnten Integrationen zur Entfaltung erstrecken sich bis in das Unendliche. Dies ist bei numerischer Integration nicht durchführbar, so daß die Integrale bei einem bestimmten Wert A angeschnitten werden müssen. Das erzeugt aber bei dem erfindungsgemäßen Verfahren keinen zusätzlichen Fehler, weil dieses Abschneiden auch als starkes Abfallen der Funktion $G_{APPR}^{-1}$ bei Argumenten größer als A dargestellt werden kann. Durch die Freiheit in der Wahl von $G_{APPR}$ beim erfindungsgemäßen Verfahren kann somit auch der Integrationsfehler aufgrund des Abschneidens des Integrationsbereichs vermieden oder verringert werden. Die Größe A wird in der Filtertheorie auch als Gesamtlänge des Filters bezeichnet.

Die Größe des Abtastintervalls bestimmt nicht nur die Genauigkeit der hochfrequenten Rekonstruktion, sondern auch die Genauigkeit der Integration. Deshalb sollte es möglichst klein gewählt werden. Andererseits wird durch zu kleine Meßintervalle nicht nur die Datenmenge sondern auch der Rechenaufwand in einem Digitalrechner zur genauen Rekonstruktion wesentlich erhöht, wie folgendes Beispiel deutlich macht:

Für die Auswertung des hochfrequenten Anteils wurde eine Gesamtlänge des Filters mit einer eine Wellenlänge von 60m ergebenden Grenzfrequenz gewählt, damit der sich bis ins Unendliche erstreckende Integrationsbereich der Entfaltungsintegrale durch eine möglichst große Strecke gegenüber der Wagenlänge numerisch angenähert wird. Das ergibt bei dem genannten Abtastintervall von 0,5 m 121 Gewichtskoeffizienten zur näherungsweisen Entfaltung.

In Hinsicht auf diese große Zahl stellen das Abtastintervall und die Länge des Integrationsbereiches einen guten Kompromiß dar, um praxisgerechte Aussagen über die Lage der Schienen zu gewinnen. Bei erforderlicher höherer Genauigkeit kann aber sowohl das Abtastintervall herab als auch die Länge des Filters heraufgesetzt werden.

Für die Fensterfunktion W wurde eine Dreiecksfunktion gewählt, die bei $X=0$ den Wert 1 hat und bis zur Filterlänge in X-Richtung linear abfällt. Eine Dreiecksfunktion dieser Art eignet sich deshalb, weil sie bei einer Taylorentwicklung nur erste Ableitungen enthält. Das bedeutet, der Fehler, der durch Einführung der Fensterfunktion gemacht wird, wirkt sich in der Frequenzdarstellung nur durch der Frequenz proportionale Terme und keine höheren Potenzen der Frequenz aus, die bei hohen Frequenzen wesentlich größere Änderungen hervorrufen würden.

Die über die Fensterfunktion W gewonnene approximative Faltungsfunktion $G_{APPR}$ läßt sich nach den eingangs angegebenen Gleichungen invertieren. Um aber Fehler aufgrund der hier vorliegenden diskreten Meßwerte Y zu vermeiden, wurden die Koeffizienten zur Durchführung der angenäherten Entfaltung über eine Matrixinversion gewonnen.

Praktisch wurde die inverse Matrix durch Inversion einer zyklischen Matrix berechnet, deren Kern durch die Spaltenvektoren der Koeffizienten von $G_{APPR}$ gegeben ist, wie es in dem eingangs genannten Buch von Klein, "Finite Systemtheorie", Seite 19-21 beschrieben ist.

Numerisch berechnet sich dann die approximative Entfaltung folgendermaßen:

$$Y_{1n} = \sum_{k=-N}^{N} \Gamma_k Y_{n-k}$$

Die vorhergehend beschriebenen Funktionen Y(X), $Y_1(X)$, $Y_2(X)$ und H(X) sind bei der numerischen Behandlung Zahlen, deren Reihenfolge bezüglich X durch zugefügte Indizes n dargestellt ist. Die in der Filtergleichung auftretenden Koeffizienten $\Gamma_n$ sind die diskreten Werte der Funktion $G_{APPR}^{-1}(X)$. Die Summe bildet so das eingangs genannte Integral zur approximativen Entfaltung.

Einige der im Filter 60 verwendeten 121 Koeffizienten $\Gamma_k$ seien hier beispielhaft angegeben:

$\Gamma_{-60} = 0,00976$
$\Gamma_{-59} = 0,01050$
$\Gamma_{-6} = 0,18953$
$\Gamma_{-5} = 0,57432$

$\Gamma_0 = 1{,}05639$
$\Gamma_{12} = 0{,}27820$
$\Gamma_{59} = 0{,}00978$
$\Gamma_{60} = 0{.}01011$

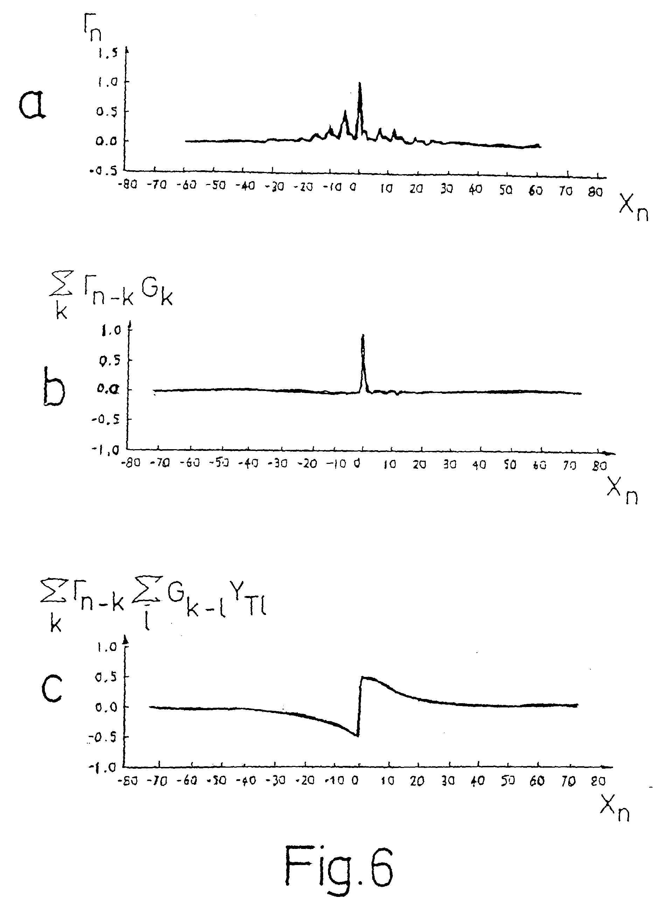

Die Größe der Koeffizienten $\Gamma_k$ ist auch in Fig. 6 a als Diagramm gezeigt. Die X-Achse ist dabei in Einheiten der Abtastintervalle angegeben.

Die an der Abszisse stehenden Ziffern bei den Diagrammen der Fig. 6 bezeichnen deswegen auch den Wert des Indexes n der jeweiligen auf der Ordinate aufgetragenen diskreten Größe.

Zur Verdeutlichung der Genauigkeit der so gefundenen Koeffizienten ist das durch die Koeffizienten gegebene Filter auf die theoretische Faltungsfunktion des Meßwagens zur Entfaltung angewandt worden. Bei einer genauen Entfaltung sollte eine Diracsche Nadelfunktion wiedergegeben werden. Die approximative Entfaltung der Faltungsfunktion liefert also eine Aussage über die Genauigkeit der Näherung.

Diese genäherte Entfaltung der theoretischen Faltungsfunktion G ist in Fig. 6b gezeigt. Es zeigt sich, daß eine Nadel wiedergegeben wird, die genäherte Entfaltung also geeignet ist, den Hochfrequenzanteil der Meßkurven zu korrigieren.

Als weiteres Beispiel ist die genäherte Entfaltung auf eine durch Faltung verfälschte Sprungfunktion angewendet worden. Das Ergebnis ist in Fig. 6 c dargestellt.

Der Sprung wird gut reproduziert. Jedoch verläuft die rekonstruierte Sprungfunktion bei sehr großen X beider Vorzeichen gegen Null, was verdeutlicht, daß große Wellenlängen mit der approximativen Entfaltung nicht richtig wiedergegeben werden.

Das langwellige Verhalten des Meßwagens wird bei großen Abständen X mit Hilfe der Filter 62 und 64 korrigiert. Wie dargestellt, ist das Filter 64 ein doppelter Integrator. Bei der numerischen Integration werden Summen aus dem vorherigen Integralwert und neuen Eingangswerten gebildet. Solche Filter, die vorherig gewonnene Filterwerte berücksichtigen, werden als rekursive Filter bezeichnet.

Derartige Filter lassen sich durch eine Gleichung

$$R_n = \sum_k d_k E_{n-k} + \sum_k c_k R_{n-k}$$

ausdrücken, wobei die $R_n$ die Resultate des Filters wiedergeben, die aus den Eingangswerten $E_n$ gewonnen werden. Die Koeffizienten $c_k$ und $d_k$ beschreiben die Filtereigenschaften.

Werden alle Koeffizienten $c_k$ Null gesetzt, erhält man wieder die Gleichung für ein nichtrekursives Filter. Wird nur ein Koeffizient $c_k$ auf festgesetzt und alle anderen $c_k=0$ gelassen, kann man mit der rekursiven Filtergleichung einen Integrator beschreiben.

Bei diesem Ausführungsbeispiel wurde die Integration wegen des guten Hochfrequenzverhaltens mit der Tickschen Regel durchgeführt, bei der die Koeffizienten für eine einfache Integration bei $\Delta X = 0{,}5 m$ die folgenden Werte annehmen:

$d_0 = 0{,}1729$
$d_1 = 0{,}6416$
$d_2 = 0{,}1729$
$c_2 = 1{,}0$

Alle anderen Koeffizienten $c_k$ und $d_k$ verschwinden.

Dieses Filter wird zweimal auf die durch das Filter 62 gefilterten Meßwerte Y angewandt, um die eingangs genannte Korrekturfunktion H für den Niederfrequenzanteil zu erhalten, der zur Rekonstruktion der Abweichungen $Y_{Tn}$ von der geraden Gleislage den Ausgangswerten $Y_{1n}$ des Filters 60 zugeschlagen wird.

Das Filter 62 wird nun so gewählt, daß die durch das Filter 64 dargestellte Doppelintegration ausreicht, den niederfrequenten Anteil der Entfaltung zu korrigieren.

Als Filtertyp wurde das Besselfilter ausgewählt, da bei diesem die Gruppenlaufzeit konstant ist. Dies ist günstig, da dann keine Phasenverschiebungen der Resultatwerte gegenüber den Ausgangswerten berücksichtigt werden müssen. Außerdem hat es einen genügend hohen Abfall bei hohen Frequenzen, so daß der durch das Filter 60 behandelte Hochfrequenzanteil nur wenig beeinflußt wird. Die Eckfrequenz des Filters 62 wurde für einen glatten Übergang zwischen Hoch- und Niederfrequenzanteil wieder entsprechend einer Wellenlänge von 60m gewählt.

Die Anpassung des Filters 62 auf ein gutes Frequenzverhalten hat gezeigt, daß man mit einem Besselfilter 6. Ordnung ein praxisgerechtes Frequenzverhalten erzielt. In dem Ausführungsbeispiel wurde dazu eine Filterkaskade aus drei Besselfiltern 2. Ordnung angewandt. Die nichtverschwindenden Koeffizienten $c_k$ und $d_k$ der drei aufeinander-folgenden Stufen hatten bei der besten Anpassung die Werte:

|  | Stufe I | Stufe II | Stufe III |
|---|---|---|---|
| $d_0$ | $1,62722 \cdot 10^{-3}$ | $1,82115 \cdot 10^{-3}$ | $2,36644 \cdot 10^{-3}$ |
| $d_1$ | $3,25443 \cdot 10^{-3}$ | $3,64229 \cdot 10^{-3}$ | $4,73288 \cdot 10^{-3}$ |
| $d_2$ | $1,62722 \cdot 10^{-3}$ | $1,82115 \cdot 10^{-3}$ | $2,36644 \cdot 10^{-3}$ |
| $c_1$ | -1,84165 | -1,85799 | -1,89780 |
| $c_2$ | 0,848161 | 0,865273 | 0,907270 |

Wenn auch die Gruppenlaufzeiten eines Besselfilters konstant sind, ergeben sich doch unterschiedliche Gruppenlaufzeiten zu den anderen Filtern. Deshalb wurden die Laufzeiten vor Summieren des Korrekturterms auf die näherungsweise Approximation durch das Filter 60 angeglichen. Außerdem wurden die Ergebnisse der gesamten Rekonstruktion auf den jeweiligen Ortsparameter X so verschoben, daß die rekonstruierten Abweichungen $Y_T'$ genau an dem Ort wiedergeben werden, an dem sie auftreten.

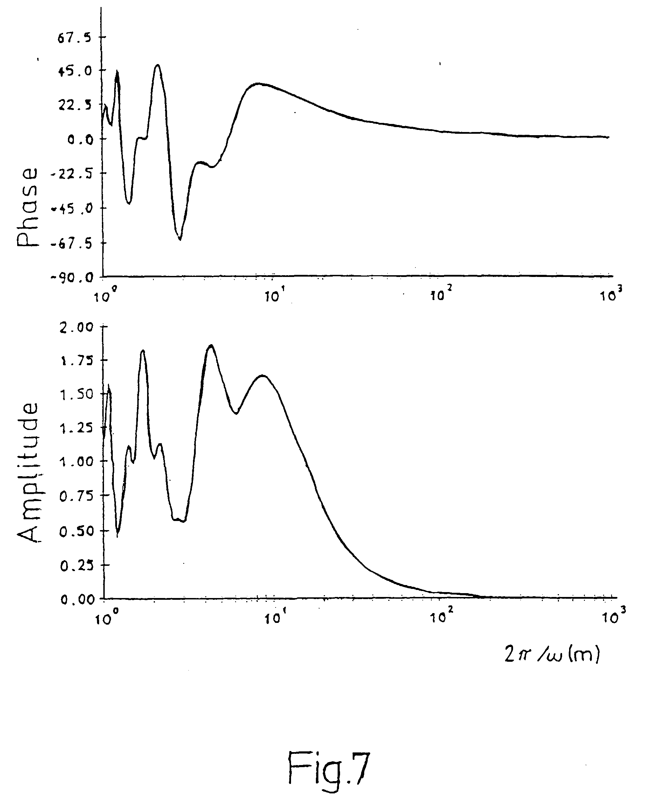

In Fig. 7 ist die Übertragungsfunktion $g(\omega)$ gezeigt, wie sie sich aus der angegebenen Faltungsfunktion G(X) in der Diskretisierung von $\Delta X = 0{,}5 m$ berechnet. Im oberen Teil ist die Phase, im unteren Teil der Absolutbetrag der Funktion gezeigt. Beide Größen sind in Abhängigkeit der Wellenlänge $2\pi/\omega$ in Metern aufgetragen. Man erkennt bei kleinen Wellenlängen starke Amplituden- und Phasenänderungen und bei Wellenlängen oberhalb der Sehnenlänge von 8,6 m einen starken Abfall in der Amplitude.

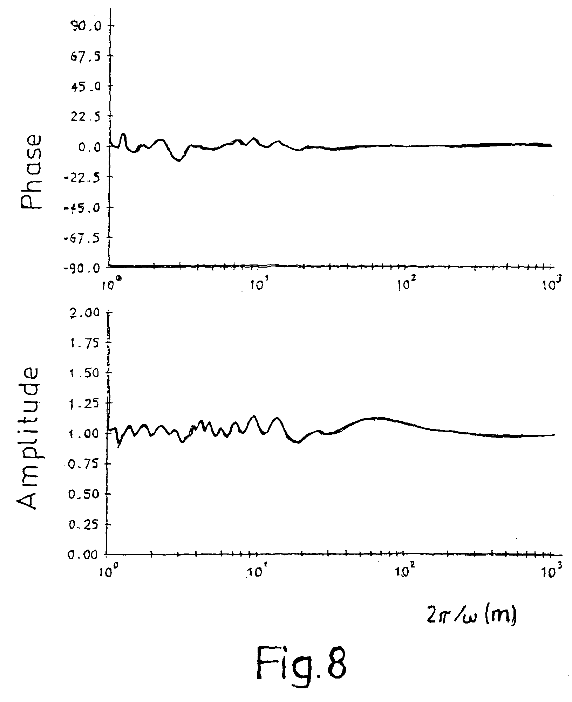

Die Fig. 8 zeigt das Frequenzverhalten der rekonstruierten Abweichungen von der geraden Gleislage und gibt im Vergleich zu Fig. 7 die Güte der Rekonstruktion wieder. Die Phase weicht nach der Rekonstruktion nur wenige Winkelgrad von Null ab, das Frequenzverhalten ist selbst bis zu Kilometerlängen praktisch konstant.

Die nach der Rekonstruktion von $Y_T$ noch verbleibenden Fehler in der Phase reichen für praktische Zwecke zum Lokalisieren von Gleislagefehler aus. Die Amplituden sind über den gesamten Wellenlängenbereich praktisch konstant, so daß für alle Wellenlängen Gleislagefehler mit gleicher Genauigkeit bestimmt werden können.

Dieses durch Rechnungen gewonnene Ergebnis ist auch in der Praxis erzielbar. Das Verhalten bei großen Wellenlängen hängt dann aber wesentlich von der Meßgenauigkeit des Meßfühlers 54 ab, da sich dessen Fehler über die Zweifachintegration quadratisch mit der vermessenen Wegstecke fortpflanzen.

Zur Verringerung der Integrationsfehler ist vorgesehen, mit dem Meßwagen eine Probefahrt über einen besonders geraden Gleisabschnitt zu fahren, um die Offsets der digitalisierten Meßgrößen genügend genau zu bestimmen, damit das ungewollte Anwachsen der Integration durch Meßfehler auf ein Minimum reduziert wird. Diese Korrektur führt gleichzeitig zu einem teilweisen Ausgleich der durch die numerische Behandlung gegebenen Integrationsfehler.

Das Ausführungsbeispiel macht neben der Anwendung des Verfahrens zur Rekonstruktion von Gleislagefehlern auch einen praxisgerechten Weg zum Ermitteln geeigneter Filtergrößen deutlich. Es wurde gezeigt, daß der Grad der Integration vorgegeben werden kann, wenn die Filter entsprechend angepaßt werden. Dies ist bei diesem Verfahren möglich, weil die Funktionen $G_{APPR}$ und f sehr frei wählbar sind.

Als weiteres Ausführungsbeispiel wird im folgenden ein Meßwagen der französischen Eisenbahn, der Mauzinwagen, angegeben. Bei diesem Meßwagen wird ebenfalls das Wandersehnenverfahren verwendet, man hat sich aber aus der Zusammenschaltung mehrerer Wandersehnen eine bessere Erfassung der Gleisbaufehler versprochen. Allerdings erhält man wesentlich mehr Echo signale, was die Auswertung erschwert. Außerdem ist auch bei diesem Meßwagen das Integral der Faltungsfunktion Null, so daß eine Entfaltung, die auch große Wegstrecken, also kleine Frequenzen, erfaßt, nur mit dem erfindungsgemäßen Verfahren möglich ist.

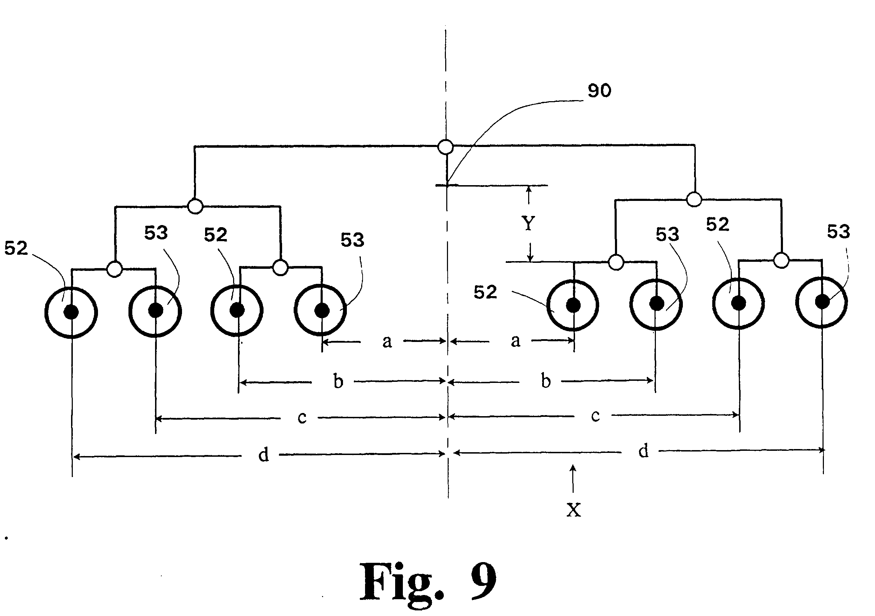

In Fig. 9 ist der Aufbau des Mauzinwagens schematisch gezeigt. Die Abtastung erfolgt durch 4 Sehnenabschnitte, die jeweils durch vorlaufende und nachlaufende Rädern 52 und 53 gebildet werden. Durch die 4 Sehnenabschnitte treten wesentlich mehr Echosignale auf als im vorhergehenden Ausführungsbeispiel. Die mechanische Kopplung soll bewirken, daß sich eine im wesentlichen gleiche Meßbasis 90 ergibt, zu der die Auslenkung eines nachlaufenden Rades 52 als Meßwert Y bestimmt werden kann.

Den hochfrequenten Anteil kann man in gleicher Weise bestimmen, wie beim vorhergehenden Meßwagen gemäß Fig. 4 diskutiert wurde. Bei der Behandlung des Niederfrequenzanteil ergibt sich aber nicht die einfache Doppelintegration, wie sie bei dem vorherigen Ausführungsbeispiel auftrat.

Unter Vernachlässigung des Nickens der Meßbasis 90 läßt sich mit den Abmessungen a, b, c, und d, wie sie in Fig. 9 schematisch eingetragen sind, der folgende Zusammenhang zwischen den Meßwerten Y und den Abweichungen $Y_T$ herstellen:

$$Y(X) = Y_T(X) - [Y_T(X + d - a) + Y_T(X + e - a) + Y_T(X + b - a) + Y_T(X)$$

$$+ Y_T(X - d - a) + Y_T(X - c - a) + Y_T(X - b - a) + Y_T(X - 2a)]/8$$

Eine Taylorentwicklung bis zur dritten Ordnung

$$Y(X) \approx C_1 \frac{dY_T(X)}{dX} + C_2 \frac{d^2 Y_T(X)}{dX^2} + C_3 \frac{d^3 Y_T(X)}{dX^3}$$

ergibt die Konstanten:

$$C_1 = a$$

$$C_2 = -(d^2 + c^2 + b^2 + 5a^2)/8$$

$$C_3 = \frac{a}{8} (d^2 + c^2 + b^2 - a^2)$$

Die erste Ableitung verschwindet bei diesem Ausführungsbeispiel also nicht. Das bedeutet, zum Erreichen von einer ähnlichen Genauigkeit bei der Rekonstruktion wie im vorhergehenden Beispiel muß man also entweder die Filterlänge für das hochfrequente Filter sehr lang wählen, damit die zweiten und dritten Ableitungen in der Taylorentwicklung nur unwesentlich beitragen oder es müssen gemäß einer Partialbruchzerlegung weitere Pole zur Rekonstruktion durch Integrale nach Gleichung 4.0 mit berücksichtigt werden. Der mathematische Aufwand steigt in beiden Fällen. Das Beispiel zeigt jedoch, daß das erfindungsgemäße Verfahren auch bei komplizierteren Meßvorrichtungen wie bei dem Mauzinwagen die Behandlung der Rekonstruktion von Gleislagefehlern gestattet.

Die Filter 60 und 62 führen in der numerischen Behandlung Matrixmultiplikationen aus. Deswegen können dafür auch neuronale Netzwerke eingesetzt werden. Neuronale Netzwerke sind in der Lage, die Ausgangswerte mit den gewünschten Ergebnissen zu vergleichen und die Matrixkoeffizienten entsprechend einzustellen. Das neuronale Netzwerk kann deshalb das benötigte Filterverhalten lernen. Es ergibt sich daher die Möglichkeit, nach Vorgabe der gewünschten Integration, verschiedene durch die Faltungsfunktion simulierte Meßkurven von einem derartigen Netzwerk bearbeiten und die Ergebnisse mit denen vor der Faltung vergleichen zu lassen, um die Matrixkoeffizienten einzustellen. Auf diese Weise läßt sich ein derartiges Filter schnell auf unterschiedliche Meßprobleme anpassen.

Das Verfahren ist nicht nur zur Ermittlung korrigierter Meßkurven geeignet, sondern kann auch zum direkten Steuern von Prozessen eingesetzt werden. Beispielsweise macht es die Ermittlung der exakten Gleisgeometrie in obengenanntem Verfahren möglich, direkt Stopf- und Richtmaschinen zur Korrektur der Gleislage anzusteuern.

Bei einer ständigen Überwachung der Gleislage durch das genannte Verfahren können langfristige Unterhaltsmaßnahmen geplant werden, da die Entwicklung relevanter Einzelfehler sehr viel besser beobachtet werden kann.

Die genannten Beispiele verdeutlichen das große Einsatzfeld bei der Rekonstruktion von Gleislagefehlern. Wie eingangs erwähnt, ist die Verbesserung der genauen Erfassung von Meßgrößen meßtechnisch immer erwünscht, so daß sich der Einsatz des Verfahrens und der beschriebenen Vorrichtungen auch für viele weitere technische Gebiete eröffnet.

**Patentansprüche**

1. Verfahren zur Korrektur einer durch mindestens ein Meßgerät aufgenommenen Meßkurve $Y(X)$ mit Meßwerten $Y$ bzw. eines mittels eines Empfängers empfangenen Signalverlaufs $Y(X)$ mit Signalwerten $Y$ bei verschiedenen Parametern $X$, für das die Auflösung des Meßgerätes oder die Störung des Signalverlaufs durch eine Funktion $G(X)$ oder deren Fouriertransformierte $g(\omega)$ beschreibbar ist, wobei die Meßwerte $Y$ sich durch eine Faltung aus echten, durch das Meßgerät ungestörten, jedoch wegen der Auflösung nicht erfaßbaren Werten $Y_T$ oder die Signalwerte Y sich durch eine Faltung aus ungestörten Signalen $Y_T$ ergeben als:

$$Y(X) = \int\limits_{-\infty}^{+\infty} G(X - X')Y_T(X')dX',$$

dadurch gekennzeichnet, daß aus der Meßkurve oder dem Signalverlauf $Y(X)$ entsprechend ihrer bzw. seiner Fourierdarstellung $y(\omega)$ ein hochfrequenter Anteil $Y_1(X)$ und ein niederfrequenter Anteil $Y_2(X)$ mit seiner Fourierdarstellung $y_2(\omega)$ so gefiltert werden, daß das Filtern für den hochfrequenten Anteil $Y_1(X)$ mit Hilfe einer angenäherten, einer Faltungsfunktion $G_{APPR}(X)$ durch Invertieren zugeordneten Entfaltungsfunktion $G_{APPR}^{-1}(X)$ durch

$$Y_1(X) = \int\limits_{-\infty}^{+\infty} G_{APPR}^{-1}(X - X')Y(X')dX'$$

und das Filtern für den niederfrequenten Anteil in der Fourierdarstellung durch

$$y_2(\omega) = f(\omega) \cdot y(\omega)$$

mit einer für hohe Frequenzen $\omega$ stark gegen Null abfallenden Funktion $f(\omega)$ darstellbar ist, wobei die Funktionen $G_{APPR}(X)$ und $f(\omega)$ so gewählt werden, daß eine Funktion

$$z(\omega) = f(\omega) \frac{g_{APPR}(\omega) \cdot g(\omega)}{g_{APPR}(\omega) - g(\omega)}$$

mit $g_{APPR}(\omega)$ der Fouriertransformierten von $G_{APPR}(X)$ durch eine Potenzreihe $p(\omega)$ mit durch die Wahl von $g_{APPR}(\omega)$ und $f(\omega)$ gegebenen Koeffizienten $a_k$

$$z(\omega) \cong p(\omega) = \sum_{k=0}^{N} a_k \omega^k$$

approximiert werden kann und eine korrigierte Meßkurve oder ein korrigierter Signalverlauf $Y_T'(X)$ durch

$$Y_T'(X) = Y_1(X) + H(X),$$

gewonnen wird, und für $H(X)$ die Differentialgleichung

$$\sum_{k=0}^{N} a_k (-i)^k \frac{d^k}{dX^k} H(X) = Y_2(X)$$

gelöst wird, und die Integrationskonstanten der Lösung $H(X)$ durch die meßtechnischen oder durch den wahren Signalverlauf gegebene Randbedingungen bestimmt sind.

2. Verfahren nach Anspruch 1, dadurch gekennzeichnet, daß die Lösung $H(X)$ durch eine Summe von N Integralen

$$A_{ln} (-i)^n e^{-i\omega_l X} \int \dots \int e^{i\omega_l X} Y_2(X)dX^n$$

gebildet wird, wobei die $\omega_l$ die N komplexen Nullstellen der Potenzreihe $p(\omega)$ bezeichnen und die Zahl der Integrationen n und die Koeffizienten $A_{ln}$ jeweils die Potenz und der Koeffizient des Partialbruchs

$$\frac{A_{ln}}{(\omega - \omega_l)^n}$$

einer Partialbruchzerlegung von $1/\,p(\omega)$ sind.

3. Verfahren nach Anspruch 2, dadurch gekennzeichnet, daß die Funktion $f(\omega)$ so gewählt ist, daß die Potenzreihe $p(\omega)$ N-ten Grades genau N Nullstellen aufweist.

4. Verfahren nach einem der Ansprüche 1 bis 3, dadurch gekennzeichnet, daß die Funktionen $G_{APPR}(X)$ und $f(\omega)$ so gewählt werden, daß $z(0) = 0$ ist.

5. Verfahren nach einem der Ansprüche 1 bis 4, dadurch gekennzeichnet, daß die Funktionen $G_{APPR}(X)$ und $f(\omega)$ so gewählt werden, daß $z(\omega) = z(-\omega)$ ist.

6. Verfahren nach einem der Ansprüche 1 bis 5, dadurch gekennzeichnet, daß die angenäherte Faltungsfunktion $G_{APPR}(X)$, aus der die Auflösung des Meßgerätes oder die die Störung des Signalverlaufs beschreibende Funktion $G(X)$ durch Multiplikation mit einer für große Absolutwerte von $X$ abfallenden Fensterfunktion $W(X)$ gewonnen wird, die bei $X=0$ den Wert 1 annimmt.

7. Verfahren nach Anspruch 6, dadurch gekennzeichnet, daß zweite und höhere Ableitungen der Fensterfunktion $W(X)$ in der Umgebung von X=0 verschwinden.

8. Verfahren nach einem der Ansprüche 1 bis 7, dadurch gekennzeichnet, daß das Filtern über digitale Filter erfolgt.

9. Verfahren nach Anspruch 8, dadurch gekennzeichnet, daß das Filter zur Gewinnung des niederfrequenten Anteils $Y_2(X)$ ein rekursives Filter ist.

10. Verfahren nach Anspruch 8 oder 9, dadurch gekennzeichnet, daß die Potenzreihe $p(\omega)$ nur einen einzigen nicht verschwindenden Koeffizienten $a_k$ enthält, so daß die Lösung $H(X)$ der Differentialgleichung durch eine Ein- oder Mehrfachintegration des niederfrequenten Anteils $Y_2(X)$ gewonnen wird und die Koeffizienten der digitalen Filter durch Wahl von $f(\omega)$ und $g_{APPR}(\omega)$ für $z(\omega) \approx p(\omega)$ angepaßt werden.

11. Verfahren nach einem der Ansprüche 8 bis 10, dadurch gekennzeichnet, daß das Filter zur Gewinnung des niederfrequenten Anteils $Y_2(X)$ ein Besselfilter ist, dessen Ordnung so gewählt wird, daß der Hochfrequenz- und der Niederfrequenzanteil von $y_T(\omega)$, der Fouriertransformierten von $Y_T(X)$, mit nur geringer Steigung ineinander übergehen, wenn die Meßkurve oder der Signalverlauf $Y(X)$ durch $G_{APPR}(X)$ simuliert wird.

12. Verfahren nach Anspruch 11, dadurch gekennzeichnet, daß für die Integration die Ticksche Regel angewendet wird.

13. Verfahren nach Anspruch 11 oder 12, dadurch gekennzeichnet, daß vor Integration ein weiteres Bandpaßfilter verwendet wird, insbesondere eines, dessen Bandbreite auf die Integrationsschrittweite angepaßt und/oder so eingestellt ist, daß eine sehr langwellige Drift infolge eines Offseffehlers bei der Integration beschränkt wird.

14. Verfahren nach einem der Ansprüche 8 bis 13, dadurch gekennzeichnet, daß das Filtern zur Gewinnung des hochfrequenten Anteils $Y_1(X)$ ein nichtrekursives Filter ist.

15. Vorrichtung zur Durchführung eines der Verfahren nach Anspruch 1 bis 14, um eine durch ein Meßgerät aufgenommene Meßkurve oder einen mittels eines Empfängers empfangenen Signalverlauf $Y(X)$ bezüglich einer dem Meßgerät zugehörigen oder die Störung des Signalverlaufs beschreibenden Faltungsfunktion $G(X)\,zu$ korrigieren, von der mindestens ihre Fouriertransformierte $g(\omega)$ bekannt ist, gekennzeichnet durch zwei Filter (10,12; 62,64) zum Filtern eines hochfrequenten Anteils $Y_1(X)$ mit seiner Fouriertransformierten $y_1(\omega)$ und eines niederfrequenten Anteils $Y_2(X)$ mit seiner Fouriertransformierten $y_2(\omega)$ aus der Meßkurve oder dem Signalverlauf $Y(X)$ mit ihrer bzw. seiner Fouriertransformierten $y(\omega)$, deren Filtercharakteristiken in der Fourierdarstellung durch zwei Funktionen $f$

($\omega$) und $g_{APPR}(\omega)$ als

$$y_1(\omega) = y(\omega)/g_{APPR}(\omega)$$

und

$$y_2(\omega) = f(\omega) \cdot y(\omega)$$

gegeben sind, sowie durch eine Einrichtung (14; 64) zur Erzeugung eines Signals, das einer Funktion $H(X)$ proportional ist, mit der die Differentialgleichung

$$\sum_{k=0}^{N} a_k (-i)^k \frac{d^k}{dX^k} H(X) = Y_2(X),$$

gelöst wird, wobei die meßtechnischen Randbedingungen in den Integrationskonstanten erfaßt sind und bei der die durch die Wahl von $g_{APPR}(\omega)$ und $f(\omega)$ vorgegebenen Koeffizienten $a_k$ und die maximal berücksichtigte Differentiation N aus einer genäherten Potenzreihe $p(\omega)$ für eine Funktion

$$z(\omega) = f(\omega) \frac{g_{APPR}(\omega) \cdot g(\omega)}{g_{APPR}(\omega) - g(\omega)}$$

mit

$$z(\omega) \cong p(\omega) = \sum_{k=0}^{N} a_k \omega^k$$

bestimmt sind, sowie durch eine Summiereinrichtung (16), die den hochfrequenten Anteil $Y_1(X)$ zu dem so erzeugten, der Lösung $H(X)$ der Differentialgleichung proportionalen Signal addiert, daß sich eine korrigierte Meßkurve

$$Y_T'(X) = Y_1(X) + H(X),$$

ergibt.

16. Vorrichtung nach Anspruch 15 zur Durchführung eines Verfahrens nach Anspruch 2, dadurch gekennzeichnet, daß die Einrichtung (14; 64) zur Erzeugung des der Lösung der Differentialgleichung proportionalen Signals mindestens N Zweige (22) mit einem Multiplizierer (26), einem Integrator (14) für n-fache Integration und eine weitere Multipliziereinrichtung (28) zur Erzeugung von den Integralausdrücken

$$A_{ln} (-i)^n e^{-i\omega_l X} \int \ldots \int e^{i\omega_l X} Y_2(X) dX^n$$

proportionalen Signalen aufweist, wobei die $\omega_l$ die N komplexen Nullstellen der Potenzreihe $p(\omega)$ bezeichnen und die Zahl der Integrationen n und die Koeffizienten $A_{ln}$ jeweils die Potenz und der Koeffizient eines Partialbruchs

$$\frac{A_{ln}}{(\omega - \omega_l)^n}$$

einer Partialbruchzerlegung von $l/p(\omega)$ sind, und in der Einrichtung (14; 64) eine Summiereinrichtung (30) vorgesehen ist, welche die den Integralausdrücken proportionalen Signale aller Ausgänge der Zweige (22) summiert.

17. Vorrichtung nach Anspruch 15 zur Durchführung eines Verfahrens nach Anspruch 2, dadurch gekennzeichnet, daß die Einrichtung (14; 64) zur Erzeugung von einem der Lösung der Differentialgleichung proportionalen Signal mindestens N Zweige (22) mit auf Polterme bei Frequenzen $\omega_l$ abgestimmten Integrationsschaltungen (32, 34, 38) enthält, die von dem niederfrequenten Anteil $Y_2(X)$ so angesteuert werden, daß deren Ausgang den Integralen

$$A_{ln} \, (-i)^n \, e^{-i\omega_l X} \int \ldots \int e^{i\omega_l X} \, Y_2 \, (X) dX^n$$

proportionale Signale abgibt, wobei die $\omega_l$ die N komplexen Nullstellen der Potenzreihe $p(\omega)$ bezeichnen und die Zahl der Integrationen n und die $A_{ln}$ der jeweilige Koeffizient eines Partialbruchs

$$\frac{A_{ln}}{(\omega - \omega_l)^n}$$

einer Partialbruchzerlegung von $1/p(\omega)$ sind, und in der Einrichtung eine Summiereinrichtung (30) vorgesehen ist, welche die den Integralausdrücken proportionalen Signale aller Ausgänge der Zweige (22) summiert.

18. Vorrichtung nach einem der Ansprüche 15 bis 17, dadurch gekennzeichnet, daß die Meß- oder Signalwerte $Y$ Ströme oder Spannungen sind oder als Ströme oder Spannungen gewandelt vorliegen und die Filter (10, 12; 60, 62) sowie die Einrichtung (14; 64) elektrische Schaltungen sind.

19. Vorrichtung nach Anspruch 18, dadurch gekennzeichnet, daß die Vorrichtung ein Prozessor mit einem Speicher und mit einer Eingabevorrichtung (56) ist, über welche digital vorliegende oder digital gewandelte Meß- oder Signalwerte Y in einen Bereich des Speichers als Daten abgelegt werden, wobei ein Programm den Prozessor so steuert, daß zum Filtern der im Speicher abgelegten Daten digitale Filteralgorithmen angewendet werden und die Differentialgleichung numerisch gelöst wird.

20. Vorrichtung nach einem der Ansprüche 15 bis 19, dadurch gekennzeichnet, daß mindestens eines der beiden Filter (60, 62) als neuronales Netzwerk ausgeführt ist.

21. Anwendung eines der Verfahren nach Anspruch 1 bis 14 oder Verwendung eine der Vorrichtungen nach Anspruch 15 bis 20 zur Rekonstruktion von Lagefehlern bei Bahngleisen aus geometrischen Relativmessungen.

## Claims

1. Procedure for the correction of a measurement curve $Y(X)$ recorded by at least one measuring instrument and having measurement values $Y$ or of a signal waveform $Y(X)$ received by means of a receiver and having signal values $Y$ with various parameters $X$, for which procedure the resolution of the measuring instrument or the disturbance of the signal waveform is describable by a function $G(X)$ or its Fourier transform $g(\omega)$, where the measurement values $Y$ result, through a convolution from real values $Y_T$ undisturbed by the measuring instrument but not detectable because of the resolution, or the signal values Y result, through a convolution from undisturbed signals $Y_T$, as:

$$Y(X) \quad = \quad \int_{-\infty}^{+\infty} G(X - X') Y_T(X') dX',$$

characterized in that, from the measurement curve or the signal waveform $Y(X)$, in accordance with its Fourier representation $y(w)$, a high-frequency component $Y_1(X)$ and a low-frequency component $Y_2(X)$ with its Fourier representation $y_2(\omega)$ are filtered such that the filtering for the high-frequency component $Y_1(X)$ is representable with the aid of an approximate deconvolution function $G_{APPR}^{-1}(X)$, associated by inverting with a convolution function

$G_{APPR}(X)$, by

$$Y_1(X) = \int_{-\infty}^{+\infty} G_{APPR}^{-1}(X - X')Y(X')dX'$$

and the filtering for the low-frequency component is representable in the Fourier representation by

$$y_2(\omega) = f(\omega) \cdot y(\omega)$$

with a function $f(\omega)$ which falls sharply to zero for high frequencies $\omega$, where the functions $G_{APPR}(X)$ and $f(\omega)$ are chosen such that a function

$$z(\omega) = f(\omega)\frac{g_{APPR}(\omega) \cdot g(\omega)}{g_{APPR}(\omega) - g(\omega)}$$

with $g_{APPR}(\omega)$ the Fourier transform of $G_{APPR}(X)$ can be approximated by a power series $p(\omega)$ with coefficients $a_k$ given by the choice of $g_{APPR}(\omega)$ and $f(\omega)$

$$z(\omega) \cong p(\omega) \sum_{k=0}^{N} a_k \omega^k$$

and a corrected measurement curve or a corrected signal waveform $Y_T'(X)$ is obtained by

$$Y_T'(X) = Y_1(X) + H(X),$$

and for $H(X)$ the differential equation

$$\sum_{k=0}^{N} a_k (-i)^k \frac{d^k}{dX^k} H(X) = Y_2(X)$$

is solved, and the integration constants of the solution $H(X)$ are determined by the metrological boundary conditions or the boundary conditions given by the true signal waveform.

2.  Procedure according to Claim 1, characterized in that the solution $H(X)$ is formed by a sum of N integrals

$$A_{ln} (-i)^n e^{i\omega_l X} \int \ldots \int e^{i\omega_l X} Y_2(X)dX^n,$$

where the $\omega_l$'s denote the N complex zeros of the power series $p(\omega)$ and the number of integrations n and the coefficients $A_{ln}$ are in each case the power and the coefficient of the partial fraction

$$\frac{A_{ln}}{(\omega - \omega_l)^n}$$

of an expansion of partial fractions of $1/p(\omega)$.

3. Procedure according to Claim 2, characterized in that the function $f(\omega)$ is chosen such that the power series $p(\omega)$ of Nth degree has exactly N zeros.

4. Procedure according to one of Claims 1 to 3, characterized in that the functions $G_{APPR}(X)$ and $f(\omega)$ are chosen such that $z(0)=0$.

5. Procedure according to one of Claims 1 to 4, characterized in that the functions $G_{APPR}(X)$ and $f(\omega)$ are chosen such that $z(\omega)=z(-\omega)$.

6. Procedure according to one of Claims 1 to 5, characterized in that the approximate convolution function $G_{APPR}(X)$, from which the resolution of the measuring instrument or the function $G(X)$ describing the disturbance of the signal waveform is obtained by multiplication by a window function $W(X)$ which decreases with large absolute values of X and assumes the value 1 at $X=0$.

7. Procedure according to Claim 6, characterized in that second or higher derivatives of the window function $W(X)$ vanish in the neighbourhood of $X=0$.

8. Procedure according to one of Claims 1 to 7, characterized in that the filtering is effected by way of digital filters.

9. Procedure according to Claim 8, characterized in that the filter for obtaining the low-frequency component $Y_2(X)$ is a recursive filter.

10. Procedure according to Claim 8 or 9, characterized in that the power series $p(\omega)$ contains only a single nonvanishing coefficient $a_k$, so that the solution $H(X)$ of the differential equation is obtained by a single or multiple integration of the low-frequency component $Y_2(X)$ and the coefficients of the digital filters are adapted by choice of $f(\omega)$ and $G_{APPR}(\omega)$ for $z(\omega) \approx p(\omega)$.

11. Procedure according to one of Claims 8 to 10, characterized in that the filter for obtaining the low-frequency component $Y_2(X)$ is a Bessel filter, whose order is chosen such that the high-frequency component and the low-frequency component of $y_T(\omega)$, the Fourier transform of $Y_T(X)$, merge into each other with only a low gradient if the measurement curve or the signal waveform $Y(X)$ is simulated by $G_{APPR}(X)$.

12. Procedure according to Claim 11, characterized in that Tick's rule is applied for the integration.

13. Procedure according to Claim 11 or 12, characterized in that prior to integration a further band-pass filter is used, in particular one whose bandwidth is adapted to the integration increment and/or is set such that a drift of very long wavelength owing to an offset error in the integration is limited.

14. Procedure according to one of Claims 8 to 13, characterized in that the filtering [sic] for obtaining the high-frequency component $Y_1(X)$ is a nonrecursive filter.

15. Apparatus for carrying out one of the procedures according to Claim 1 to 14, in order to correct a measurement curve recorded by a measuring instrument or a signal waveform $Y(X)$ received by means of a receiver with respect to a convolution function $G(X)$ which is associated with the measuring instrument or describes the disturbance of the signal waveform and of which at least its Fourier transform $g(\omega)$ is known, characterized by two filters (10,12; 62,64) for filtering a high-frequency component $Y_1(X)$ with its Fourier transform $y_1(\omega)$ and a low-frequency component $Y_2(X)$ with its Fourier transform $y_2(\omega)$ from the measurement curve or the signal waveform $Y(X)$ with its Fourier transform $y(\omega)$, the filter characteristics of which are given in the Fourier representation by two functions $f(\omega)$ and $g_{APPR}(\omega)$ as

$$y_1(\omega)=y(\omega)/g_{APPR}(\omega)$$

and

$$y_2(\omega) = f(\omega) \cdot y(\omega),$$

and also by a device (14;64) for generating a signal which is proportional to a function $H(X)$, with which the differential equation

$$\sum_{k=0}^{N} a_k (-i)^k \frac{d^k}{dX^k} H(X) = Y_2(X)$$

is solved, where the metrological boundary conditions are included in the integration constants and in which the coefficients $a_k$ specified by the choice of $g_{APPR}(\omega)$) and $f(\omega)$ and the maximum differentiation N considered are determined from an approximate power series $p(\omega)$ for a function

$$z(\omega) = f(\omega) \frac{g_{APPR}(\omega) \cdot g(\omega)}{g_{APPR}(\omega) - g(\omega)}$$

where

$$z(\omega) \cong p(\omega) \sum_{k=0}^{N} a_k \omega^k ,$$

and also by a summing device (16) which adds the high-frequency component $Y_1(X)$ to the signal thus generated and proportional to the solution $H(X)$ of the differential equation, giving a corrected measurement curve

$$Y_T'(X) = Y_1(X) + H(X).$$

16. Apparatus according to Claim 15 for carrying out a procedure according to Claim 2, characterized in that the device (14; 64) for generating the signal proportional to the solution of the differential equation has at least N branches (22) with a multiplier (26), an integrator (14) for n-fold integration and a further multiplying device (28) for generating signals proportional to the integral expressions

$$A_{ln} (-i)^n e^{-i\omega_l X} \int \dots \int e^{-i\omega_l X} Y_2(X) dX^n,$$

where the $\omega_l$'s denote the N complex zeros of the power series $p(\omega)$ and the number of integrations n and the coefficients $A_{ln}$ are in each case the power and the coefficient of a partial fraction

$$\frac{A_{ln}}{(\omega - \omega_l)^n}$$

of an expansion of partial fractions of $1/p(\omega)$, and there is provided in the device (14; 64) a summing device (30) which sums the signals, proportional to the integral expressions, of all the outputs of the branches (22).

17. Apparatus according to Claim 15 for carrying out a procedure according to Claim 2, characterized in that the device (14; 64) for generating a signal proportional to the solution of the differential equation contains at least N branches (22) with integrating circuits (32, 34, 38) which are coordinated with pole terms at frequencies $\omega_l$ and are driven by the low-frequency component $Y_2(X)$ such that their output emits signals proportional to the integrals

$$A_{ln} \, (-i)^n \, e^{-i\omega_l X} \int ... \int e^{-i\omega_l X} \, Y_2(X) \, dX^n,$$

where the $\omega_l$'s denote the N complex zeros of the power series $p(\omega)$ and the number of integrations n and the $A_{ln}$'s are the respective coefficient of a partial fraction

$$\frac{A_{ln}}{(\omega - \omega_l)^n}$$

of an expansion of partial fractions of $1/p(\omega)$, and there is provided in the device a summing device (30) which sums the signals, proportional to the integral expressions, of all the outputs of the branches (22).

**18.** Apparatus according to one of Claims 15 to 17, characterized in that the measurement values or signal values $Y$ are currents or voltages or are present in a form converted as currents or voltages, and the filters (10, 12;60, 62) and also the device (14; 64) are electrical circuits.

**19.** Apparatus according to Claim 18, characterized in that the apparatus is a processor with a memory and with an input device (56), via which digitally present or digitally converted measurement values or signal values Y are stored in an area of the memory as data, a program controlling the processor such that digital filter algorithms are applied to filter the data stored in the memory and the differential equation is numerically solved.

**20.** Apparatus according to one of Claims 15 to 19, characterized in that at least one of the two filters (60, 62) is designed as a neural network.

**21.** Application of one of the procedures according to Claim 1 to 14 or use of one of the apparatuses according to Claim 15 to 20 for the reconstruction of positional errors in railway tracks from geometrical relative measurements.

**Revendications**

**1.** Procédé pour corriger une courbe de mesure Y(X), enregistrée par au moins un appareil de mesure avec des valeurs de mesure Y, ou une variation de signal Y(X) reçue au moyen d'un récepteur avec des valeurs de signal Y pour différents paramètres X, pour lequel la résolution de l'appareil de mesure ou la perturbation de la variation du signal peut être décrite par une fonction G(X) ou par une transformée de Fourier g($\omega$), les valeurs de mesure Y étant obtenues par convolution à partir de valeurs réelles $Y_T$, qui ne sont pas perturbées par l'appareil de mesure, mais ne peuvent pas être détectées en raison de la résolution, ou les valeurs Y du signal étant obtenues au moyen d'une convolution à partir de signaux $Y_T$ non perturbés, sous la forme :

$$Y(X) \; = \; \int_{-\infty}^{+\infty} G(X{-}X') \, Y_T(X') \, dX' \, ,$$

caractérisé en ce qu'une composante à hautes fréquences $Y_1(X)$ et une composante à basses fréquences $Y_2(X)$ avec sa représentation de Fourier $y_2(\omega)$ sont filtrées à partir de la courbe de mesure ou à partir de la variation de signal Y(X) en fonction de la représentation de Fourier y($\omega$) de la courbe de mesure ou de la variation du signal de telle sorte que le filtrage pour la composante à hautes fréquences $Y_1(X)$ à l'aide d'une fonction de déconvolution approximée $G^{-1}_{APPR}(X)$ associée par inversion à une fonction de convolution $G_{APPR}(X)$, peut être représenté par

$$Y_1(X) \; = \; \int_{-\infty}^{+\infty} G^{-1}_{APPR}(X{-}X') \, Y(X') \, dX'$$

et le filtrage pour la composante à basses fréquences dans la représentation de Fourier peut être représenté par

$$y_2(\omega) = f(\omega).y(\omega)$$

avec une fonction $f(\omega)$ qui tend fortement vers zéro pour des fréquences $\omega$ élevées, les fonctions $G_{APPR}(X)$ et $f(\omega)$ étant choisies de telle sorte que l'on peut approximer une fonction

$$z(\omega) = f(\omega)\,\frac{g_{APPR}(\omega)\,.g(\omega)}{g_{APPR}(\omega)\,\text{-}g(\omega)}$$

dans laquelle $g_{APPR}(\omega)$ est la transformée de Fourier de $G_{APPR}(X)$ par une série exponentielle $p(\omega)$ avec des coefficients $a_k$ définis par le choix de $g_{APPR}(\omega)$ et de $f(\omega)$

$$z(\omega) \cong p(\omega) = \sum_{k=0}^{N} a_k\omega^k$$

et une courbe de mesure corrigée ou une variation corrigée de signal $Y_T{}'(X)$ est obtenue conformément à

$$Y_T{}'(X) = Y_1(X) + H(X)$$

et pour H(X) on résout l'équation différentielle

$$\sum_{k=0}^{N} a_k(-i)^k \frac{d^k}{dX^k} H(X) = Y_2(X)$$

et les constantes d'intégration de la solution H(X) sont déterminées par les conditions marginales de la technique de mesure ou par les conditions marginales fixées par la variation réelle du signal.

2. Procédé selon la revendication 1, caractérisé en ce que la solution H(X) est formée par la somme de N intégrales

$$A_{ln}\,(-i)^n\,e^{-i\omega lX} \int \dots \int e^{i\omega lX}\,Y_2(X)dX^n$$

les $\omega_l$ désignant N points d'annulation complexes de la série exponentielle $p(\omega)$ et le nombre des intégrations n et les coefficients $A_{ln}$ désignant respectivement la puissance et le coefficient de la fraction partielle

$$\frac{A_{ln}}{(\omega\text{-}\omega_l)^n}$$

d'une décomposition en fractions partielles de $1/p(\omega)$.

3. Procédé selon la revendication 2, caractérisé en ce que la fonction $f(\omega)$ est choisie de telle sorte que la série exponentielle $p(\omega)$ du N-ème degré possède précisément N points d'annulation.

4. Procédé selon l'une des revendications 1 à 3, caractérisé en ce que les fonctions $G_{APPR}(X)$ et $f(\omega)$ sont choisies de telle sorte que l'on a z(0) = 0.

5. Procédé selon l'une des revendications 1 à 4, caractérisé en ce que les fonctions $G_{APPR}(X)$ et $f(\omega)$ sont choisies de telle sorte que l'on a $z(\omega) = z(-\omega)$.

**6.** Procédé selon l'une des revendications 1 à 5, caractérisé en ce que la fonction de convolution approximée $G_{APPR}$ (X), à partir de laquelle la résolution de l'appareil de mesure ou la fonction G(X), décrite par la perturbation de la variation du signal, est obtenue par multiplication par une fonction fenêtre W(X), qui diminue pour des valeurs absolues élevées de X et qui prend la valeur 1 pour X=0.

**7.** Procédé selon la revendication 6, caractérisé en ce que la dérivée seconde et des dérivées supérieures de la fonction fenêtre W(X) disparaissent au voisinage de X=0.

**8.** Procédé selon l'une des revendications 1 à 7, caractérisé en ce que le filtrage s'effectue à l'aide de filtres numériques.

**9.** Procédé selon la revendication 8, caractérisé en ce que le filtre servant à obtenir la composante à basses fréquence $Y_2(X)$ est un filtre récursif.

**10.** Procédé selon la revendication 8 ou 9, caractérisé en ce que la série exponentielle p(ω) contient uniquement un seul coefficient $a_k$ qui ne disparaît pas, de sorte que la solution H(X) de l'équation différentielle est obtenue au moyen d'une seule intégration ou d'une intégration multiple de la composante à basses fréquences $Y_2(X)$, et les coefficients des filtres numériques sont adaptés grâce au choix de $f(ω)$ et de $g_{APPR}(ω)$ pour $z(ω) \approx p(ω)$.

**11.** Procédé selon l'une des revendications 8 à 10, caractérisé en ce que le filtre pour l'obtention de la composante à basses fréquences $Y_2(X)$ est un filtre de Bessel, dont l'ordre est choisi de manière que la composante à hautes fréquences et la composante à basses fréquences $y_T(ω)$, c'est-à-dire la transformée de Fourier de $Y_T(X)$, se rejoignent seulement avec une faible pente lorsque la courbe de mesure ou la variation de signal Y(X) est simulée par $G_{APPR}(X)$.

**12.** Procédé selon la revendication 11, caractérisé en ce que pour l'intégration, on utilise la règle de Tick.

**13.** Procédé selon la revendication 11 ou 12, caractérisé en ce qu'avant l'intégration on utilise un autre filtre passe-bande, notamment un filtre passe-bande dont la largeur de bande est adaptée et/ou réglée sur la largeur du pas d'intégration de telle sorte qu'une dérive de très longue durée due à une erreur de décalage lors de l'intégration est limitée.

**14.** Procédé selon l'une des revendications 8 à 13, caractérisé en ce que le filtrage pour l'obtention de la composante à hautes fréquences $Y_1(X)$ est réalisée avec un filtre non récursif.

**15.** Dispositif pour la mise en oeuvre d'un procédé selon l'une des revendications 1 à 14, pour corriger une courbe de mesure enregistrée par un appareil de mesure, ou une variation de signal Y(X) reçue au moyen d'un récepteur, par rapport à une fonction de convolution G(X) qui est associée à l'appareil de mesure ou décrit la perturbation de la variation du signal et dont au moins la transformée de Fourier g(ω) est connue, caractérisé par deux filtres (10, 12 ; 62, 64) qui servent à filtrer une composante à hautes fréquences $Y_1(X)$, dont la transformée de Fourier est $y_1(ω)$, et une composante à basses fréquences $Y_2(X)$, dont la transformée de Fourier est $y_2(ω)$, à partir de la courbe ou de la variation de signal Y(X), dont la transformée de Fourier est $y(ω)$, et dont les caractéristiques de filtres sont définies dans la représentation de Fourier par deux fonctions $f(ω)$ et $g_{APPR}(ω)$ sous la forme

$$Y_1(ω) = y(ω)/g_{APPR}(ω)$$

et

$$Y_2(ω) = f(ω).y(ω)$$

ainsi que par un dispositif (14;64) pour produire un signal, qui est proportionnel à une fonction H(X), à l'aide de laquelle est résolue l'équation différentielle

$$\sum_{k=0}^{N} a_k \, (-i)^k \, \frac{d^k}{dX^k} \, H(X) = Y_2(X)$$

les conditions marginales de la technique de mesure étant insérées dans les constantes d'intégration, tandis que les coefficients $a_k$ prédéterminés par le choix de $g_{APPR}(\omega)$ et de $f(\omega)$ et la différentiation considérée maximale N sont déterminées à partir d'une série exponentielle approximée $p(\omega)$ pour une fonction

$$z(\omega) = f(\omega) \frac{g_{APPR}(\omega) \cdot g(\omega)}{g_{APPR}(\omega) - g(\omega)}$$

avec

$$z(\omega) \cong p(\omega) = \sum_{k=0}^{N} a_k \omega^k$$

ainsi que par un dispositif de sommation (16), qui additionne la composante à hautes fréquences $Y_1(X)$ au signal ainsi produit, qui est proportionnel à la solution H(X) de l'équation différentielle, de sorte qu'on obtient une courbe de mesure corrigée

$$Y_T'(X) = Y_1(X) + H(X).$$

16. Dispositif selon la revendication 15 pour la mise en oeuvre d'un procédé selon la revendication 2, caractérisé en ce que le dispositif (14;64) servant à produire le signal proportionnel à la solution de l'équation différentielle, comporte N branches (22) comportant un multiplicateur (26), un intégrateur (14) pour une intégration exécutée n fois et un dispositif de multiplication (28) pour produire des signaux proportionnels aux expressions intégrales

$$A_{ln} \, (-i)^n e^{-i\omega lX} \int \ldots \int e^{i\omega lX} Y_2(X) \, dX^n$$

les $\omega_l$ désignant N points d'annulation complexes de la série exponentielle $p(\omega)$ et le nombre des intégrations n et les coefficients $A_{ln}$ désignant respectivement la puissance et le coefficient d'une fraction partielle

$$\frac{A_{ln}}{(\omega - \omega_1)^n}$$

d'une décomposition en fractions partielles de $1/p(\omega)$, et dans le dispositif (14;64) il est prévu un dispositif de sommation (30) qui forme la somme des signaux, qui sont proportionnels aux expressions intégrales, de toutes les sorties des branches (22).

17. Dispositif selon la revendication 15 pour la mise en oeuvre d'un procédé selon la revendication 2, caractérisé en ce que le dispositif (14;64) servant à produire le signal proportionnel à la solution de l'équation différentielle contient N branches (22) comportant des circuits d'intégration (32,34,38), qui sont accordés sur des termes de pôles pour des fréquences $\omega_l$ et qui sont commandés par la composante à basses fréquences $Y_2(X)$ de telle sorte que la sortie du dispositif délivre des signaux proportionnels aux intégrales

$$A_{ln} \, (-i)^n e^{-i\omega lX} \int \ldots \int e^{i\omega lX} Y_2(X) \, dX^n$$

les $\omega_l$ désignant N points d'annulation complexes de la série exponentielle $p(\omega)$ et le nombre des intégrations n et

les coefficients $A_{ln}$ désignant respectivement la puissance et le coefficient de la fraction partielle

$$\frac{A_{ln}}{(\omega-\omega_1)^n}$$

d'une décomposition en fractions partielles de $1/p(\omega)$, et dans le dispositif il est prévu un dispositif de sommation (30) qui forme la somme des signaux, qui sont proportionnels aux expressions intégrales, de toutes les sorties des branches (22).

18. Dispositif selon l'une des revendications 15 à 17, caractérisé en ce que les valeurs de mesure et les valeurs de signal Y sont des courants ou des tensions ou sont présents en étant transformés en courants ou tensions, et que les filtres (10,12;60,62) ainsi que le dispositif (14;64) sont des circuits électriques.

19. Dispositif selon la revendication 18, caractérisé en ce que le dispositif est un processeur comportant une mémoire et un dispositif d'entrée (56), à l'aide desquels des valeurs de mesure ou des valeurs de signal Y présentes sous forme numérique ou converties sous forme numérique sont mémorisées sous la forme de données dans une zone de la mémoire, et un programme commandant le processeur de sorte que les algorithmes de filtrage numérique sont utilisés pour le filtrage des données mémorisées dans la mémoire et l'équation différentielle est résolue numériquement.

20. Dispositif selon l'une des revendications 15 à 19, caractérisé en ce qu'au moins l'un des deux filtres (60, 62) est agencé sous la forme d'un réseau neuronal.

21. Application de l'un des procédés selon les revendications 1 à 14 ou utilisation de l'un des dispositifs selon les revendications 15 à 20 pour la reconstitution d'écarts de position de voies ferrées à partir de mesures géométriques relatives.

Fig. 1

Fig. 2

a

b

c

d

**Fig. 3**

60

56

$G^{-1}_{APPR}$

$Y_{1n}$

50

$Y_n$

A / D

$Y'_{Tn}$

$H_n$

Y

$Y_{2n}$

f

∫∫

$X_n$

62

64

58

52 54 53

**Fig. 4**

EP 0 697 672 B1

Fig.5

Fig.6

Fig.7

Fig.8

EP 0 697 672 B1

Fig. 9